# EUROPEAN PATENT SPECIFICATION

(11) **EP 4 749 354 B1**
(45) Date of publication and mention of the grant of the patent: **25.11.2026**
(21) Application number: 25211669.4
(22) Date of filing: 28.10.2025
(51) Int. Cl.: G02F 1/133, G09G 3/00

(54) **OPTICAL UNITS AND METHODS IMPLEMENTED THEREOF**
OPTISCHE EINHEITEN UND VERFAHREN ZUR IMPLEMENTIERUNG DAVON
UNITÉS OPTIQUES ET PROCÉDÉS MIS EN OEUVRE DANS CELLES-CI

(30) Priority: 25.11.2024 FI 20246381
(43) Date of publication of application: 27.05.2026
(73) Proprietor: IXI Eyewear Oy, 02150 Espoo (FI)
(72) Inventor: Timonen, Juha, 02700 Kauniainen (FI); Melakari, Klaus, 02140 Espoo (FI); Pitkänen, Ari, 01200 Vantaa (FI)
(74) Representative: Moosedog Oy

(56) References cited:
- US-A- 4 795 248
- US-A1- 2022 258 456

## Description

### TECHNICAL FIELD

The present disclosure relates to optical units. Moreover, the present disclosure relates to methods implemented by optical units.

### BACKGROUND

In recent times, a demand for liquid crystal technologies has grown significantly, driven by their widespread use in consumer electronics, scientific instruments, and various other applications. Moreover, liquid crystal material used in such liquid crystal technologies comprises mesogens, which are molecular units within said liquid crystal (LC) material that exhibit long-range orientational order. However, performance and longevity of the liquid crystal material can be adversely affected by degradation of the mesogens over time due to various factors (for example, such as a high temperature, an ultraviolet light exposure, a prolonged use, and the like).

Conventionally, several existing methods monitor state of the mesogens. These methods often rely on indirect measurements of optical properties or electrical properties to infer the state of the mesogens. For example, spectroscopic techniques analyse an interaction of light with the LC material to detect changes in an alignment of the mesogens, while electrical impedance measurements are used to assess changes in the electrical properties of the LC material. However, the existing methods can provide some insights into behaviour of the mesogens, but have significant limitations that hinder their effectiveness.

US 2022/258456 A1 discloses a liquid crystal glazing with a controller, which sends probing signals to the liquid crystal cell and from the response determines electrical cell parameters like the cell capacitance.

Firstly, the complexity and invasiveness of the existing methods make it unusable for regular monitoring of mesogens. The indirect nature of measurements (for example, such as inferring the state of the mesogens through changes in optical properties or electrical properties) can lead to inaccuracies and a lack of immediate insights. This complexity often necessitates extensive calibration and maintenance, which further reduces their practicality for continuous monitoring. Secondly, the existing methods do not provide a straightforward way to measure ageing and historical exposure of the mesogens to environmental factors (for example, such as temperature, ultraviolet light, and the like).

Therefore, in light of the foregoing discussion, there exists a need to overcome the aforementioned drawbacks.

### SUMMARY

The aim of the present disclosure is to provide an optical unit and a method implemented by an optical unit that enables monitoring of behavior of mesogens in a liquid crystal material. The aim of the present disclosure is achieved by an optical unit and a method implemented by an optical unit as defined in the appended independent claims to which reference is made to. Advantageous features are set out in the appended dependent claims.

Throughout the description and claims of this specification, the words *"comprise", "include", "have",* and *"contain"* and variations of these words, for example *"comprising"* and *"comprises",* mean *"including but not limited to",* and do not exclude other components, items, integers or steps not explicitly disclosed also to be present. Moreover, the singular encompasses the plural unless the context otherwise requires. In particular, where the indefinite article is used, the specification is to be understood as contemplating plurality as well as singularity, unless the context requires otherwise.

### BRIEF DESCRIPTION OF THE DRAWINGS

FIG. 1A illustrates a schematic illustration of an optical unit, FIG. 1B illustrates an equivalent circuit of a test circuit, and FIG. 1C illustrates an actual circuit of the test circuit, in accordance with an embodiment of the present disclosure;
FIG. 2 illustrates an exemplary implementation of a test circuit when incorporated into a Wheatstone bridge configuration, in accordance with an embodiment of the present disclosure;
FIG. 3 shows a schematic illustration of an optical unit, in accordance with an embodiment of the present disclosure;
FIGs. 4A and 4B illustrate graphical representation of a variation in a sine wave response of capacitance in an optical element, in accordance with an embodiment of the present disclosure; and
FIG. 5 illustrates steps of a method implemented by an optical unit, in accordance with an embodiment of the present disclosure.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practising the present disclosure are also possible.

In a first aspect, the present disclosure provides an optical unit comprising:
an optical element comprising:
   a first substrate and a second substrate;
   a liquid crystal material comprising mesogens;
   at least one first electrode deposited on a surface of the first substrate and disposed between the first substrate and the liquid crystal material;
   at least one second electrode deposited on a surface of the second substrate and disposed between the second substrate and the liquid crystal material;
   a test circuit comprising:
      a first resistor formed by a trace of the at least one first electrode;
      a second resistor formed by a trace of the at least one second electrode; and
      a test capacitor formed by the liquid crystal material,
      wherein the first resistor, the second resistor, and the test capacitor are connected in series, the first resistor being connected to a first terminal of the test capacitor, and the second resistor being connected to a second terminal of the test capacitor; and
at least one processor configured to:
   apply a first input signal to the test circuit to measure a first output signal, and determine a reference peak voltage of the first output signal at a first time instant;
   apply a second input signal to the test circuit to measure a second output signal, and determine a test peak voltage of the second output signal at a second time instant;
   determine a variation in a capacitance of the mesogens between the first time instant and the second time instant, by comparing the test peak voltage with the reference peak voltage;
   determine a state of the mesogens at the second time instant, based on the variation in the capacitance of the mesogens; and
   adjust at least one driving parameter of a drive signal to drive at least one of: the at least one first electrode, the at least one second electrode, to change at least one optical parameter of the optical element, based on the state of the mesogens.

In a second aspect, the present disclosure provides a method implemented by an optical unit as claimed in the first aspect, the method comprising:
applying a first input signal to the test circuit to measure a first output signal, and determine a reference peak voltage of the first output signal at a first time instant;
applying a second input signal to the test circuit to measure a second output signal, and determine a test peak voltage of the second output signal at a second time instant;
determining a variation in a capacitance of the mesogens between the first time instant and the second time instant, by comparing the test peak voltage with the reference peak voltage;
determining a state of the mesogens at the second time instant, based on the variation in the capacitance of the mesogens; and
adjusting at least one driving parameter of a drive signal to drive at least one of: the at least one first electrode, the at least one second electrode, to change at least one optical parameter of the optical element, based on the state of the mesogens.

The present disclosure provides an aforementioned optical unit, and an aforementioned method implemented by the optical unit. Herein, the optical unit is equipped with the test circuit and the at least one processor that is configured to determine the state of the mesogens. The state of the mesogens is determined by determining the variation in the capacitance over time. This allows detection of any degradation or changes in the state of the mesogens due to environmental factors or ageing. Herein, the test circuit comprising of the first resistor, the second resistor, and the test capacitor formed by the liquid crystal (LC) material, provides precise measurements of the capacitance of the mesogens. Accurate detection of the variations in the capacitance ensures reliable assessment of the state of the mesogens. The determination of the reference peak voltage and the test peak voltage allows for detection of changes in the state of the mesogens. Thereby, comparing the test peak voltage with the reference peak voltage, insights are provided into any degradation or changes due to environmental factors or ageing. Moreover, the at least one processor within the optical unit is configured to automatically adjust the at least one driving parameter of the at least one first electrode and the at least one second electrode based on the detected state of the mesogens. This facilitates maintenance of optical performance of the optical unit without any manual intervention. The method can be implemented in various liquid crystal applications, from consumer electronics to scientific instruments. This versatility makes the optical unit applicable across a wide range of industries, providing a valuable tool for maintaining performance of liquid crystal devices.

The term *"optical unit"* refers to a comprehensive assembly that manipulates light and monitors the state of the mesogens within the LC material by applying input signals, measuring output signals, and adjusting driving parameters to optimize optical performance. Notably, the optical unit comprises the optical element, the test circuit and the at least one processor. Optionally, the optical unit is implemented as an apparatus that is to be worn over eyes of a user. Examples of the optical unit include, but are not limited to, a pair of glasses, a pair of sunglasses, and smart glasses.

Throughout the present disclosure, the term *"optical element"* refers to a lens that manipulates light by changing an orientation of the mesogens in response to an electric field applied by the at least one first electrode and the at least one second electrode. For the sake of brevity, hereinafter the term *"at least one first electrode"* is used interchangeably with the term *"first electrode".* Similarly, for the sake of brevity, hereinafter the term *"at least one second electrode"* is used interchangeably with the term *"second electrode".* Herein, an optical transparency of the first substrate and the second substrate enable passage of light therethrough. The first substrate and the second substrate are arranged adjacent to each other in a manner that the LC material is encased between the first substrate and the second substrate. For example, the first substrate and the second substrate may be arranged one on top of the other in an overlapping manner, thereby forming a cavity between the first substrate and the second substrate. Herein, the cavity is filled with the LC material.

The second substrate provides a surface for the deposition of the second electrode, facilitating application of the electric field to manipulate orientation of the mesogens. Herein, the term *"electrode"* refers to a conductive layer deposited on the surface of a substrate in the optical element. Notably, the first electrode is deposited on the surface of the first substrate in the optical element. The first electrode is positioned between the first substrate and the LC material, enabling the application of the electric fields to manipulate the orientation of the mesogens within the LC material. Herein, the second electrode is deposited on the surface of the second substrate in the optical element. The second electrode is positioned between the second substrate and the LC material, enabling the application of the electric fields to control the orientation of the mesogens within the LC material. It will be appreciated that a given electrode layer may, for example, be made of indium tin oxide (ITO) or doped zinc oxide (ZnO), where ZnO is doped with aluminium or hydrogen. Alternatively, the given electrode layer may be made of a conductive polymer or of graphene.

The term *"liquid crystal material"* refers to a substance that exhibits properties between conventional liquids and solid crystals. The LC material consists of molecules that can flow like a liquid but maintain a certain degree of ordered arrangement, similar to crystals. The LC material is positioned between the first substrate and the second substrate and can have optical properties manipulated by applying electric fields through the first electrode and the second electrode, thereby changing the orientation of the mesogens. Electrically, the LC material can be modeled as a voltage-dependent capacitor. Such modelling allows the state of the mesogens to be quantified over time by correlating measured changes in the capacitance with reference calibration curves, which in turn represent temperature-dependent dielectric properties, ageing-induced drift, and manufacturing tolerances. Moreover, this modelling creates an equivalent network of finite resistorcapacitor-resistor (RCR) elements that can be reduced to a single RCR electrical model. Herein, the term *"mesogens"* refers to molecular units within the LC material for its liquid crystalline properties. The mesogens possess anisotropic shape and polarity, hence exhibiting long-range orientational order under appropriate conditions. Advantageously, the LC material emulates a dynamic sensing element for diagnostic purposes (namely, a diagnostic sensing element) and detects changes in a state of the mesogens.

Throughout the present disclosure, the term *"test circuit"* refers to a specific arrangement of electrical components designed to measure and analyse properties (for example, such as capacitance, dielectric constant, and similar) of the LC material. The test circuit includes the first resistor (R1), the second resistor (R2), and the test capacitor (C) connected in a specific configuration to assess changes in the capacitance due to variations in the state of the mesogens. It will be appreciated that the test circuit is derived by simplifying an actual circuit of the test circuit. For example, the actual circuit of the test circuit may comprise three resistors R1', R2', and R3' that are connected in series, with each resistor having a pair of capacitors connected in parallel between an electrical ground and a power source. Herein, the resistor R1' may be connected to the two capacitors C1'and C2', which are in parallel to each other and connected to the electrical ground. The resistors R2', and R3' may be connected to the two capacitors C3' and C4', C5' and C6', and C7' and C8' in a similar manner. In this regard, an equivalent circuit of the test circuit is derived by simplifying the actual circuit of the test circuit. The simplification of the test circuit to the equivalent circuit enhances measurement precision by reducing circuit complexity, which minimizes potential sources of error in the detection and analysis of the electrical properties of the LC material.

Moreover, the trace is created from an electrically-conductive material having inherent resistance (square resistance in the range of tens of ohms). Herein, the term *"trace"* refers to a conductive path on the surfaces of the first substrate or the second substrate where the first electrode and the least one second electrode are deposited, respectively. In other words, the trace is the physical pathway through which electrical signals travel between the first electrode and the second electrode and other components of the test circuit. Notably, the test capacitor is formed by the LC material itself within the test circuit. The test capacitor emulates a capacitor whose capacitance varies depending on the orientation and state of the mesogens within the LC material. Specifically, changes in capacitance are indicative of changes in the state of the mesogens, which can be monitored and analysed to determine the optical characteristics and ageing of the LC material over time.

Throughout the present disclosure, the term *"at least one processor"* refers to a computational element that is operable to execute the software framework. Moreover, the at least one processor emulates an analytical tool that is used for extracting data regarding the state of the mesogens, based on time. Additionally, such extraction is achieved via comparison of temporal time-resolved comparison between peak voltages, as will be described in detail later. The at least one processor further executes algorithms that map the temporal comparison between the reference peak voltage and the test peak voltage with the state of the mesogens, wherein each state is linked to a specific physical condition of the mesogens. This ensures that the determination of the variation in the capacitance is not an isolated measurement, but a synergistic basis for deriving physical conditions of the mesogens.

Examples of the processor may include, but are not limited to, a microprocessor, a microcontroller, a complex instruction set computing (CISC) microprocessor, a reduced instruction set computing (RISC) microprocessor, a very long instruction word (VLIW) microprocessor, or any other type of processing circuit. Advantageously, the optical element, the test circuit, and the at least one processor operates in an integrated closed-loop manner, wherein the LC material itself forms both an active material and the diagnostic sensing element. This enables highly sensitive detection of changes in the state of the mesogens without any external sensors.

Throughout the present disclosure, the first input signal initiates a response within the test circuit, allowing for measurement and analysis of the properties of the LC material, such as its capacitance and state of the mesogens. The first output signal may comprise at least one of: a voltage signal, a current signal, each reflecting the characteristics of the LC material at the first time instant. Herein, the term *"first time instant"* refers to a specific moment or a point in time when the first input signal is applied to the test circuit. Moreover, the term *"reference peak voltage"* refers to a maximum voltage level reached by the first output signal during the first time instant, when the first input signal is applied. The reference peak voltage serves as a baseline against which subsequent measurements and changes in properties of the LC material are compared. Notably, the reference peak voltage provides a standardized measure for assessing the state and behaviour of the LC material over time with respect to reference data of the optical unit, aiding in calibration and ensuring consistent and accurate performance of the optical element.

Throughout the present disclosure, the second input signal initiates a response within the test circuit, to determine changes in the state of the LC material that have occurred due to environmental factors or degradation, thereby generating an electrical output. Herein, the second output signal is an electrical output signal generated by the test circuit in response to the second input signal. The second output signal can manifest as a voltage or another measurable signal that reflects the characteristics of the LC material at the second time instant. In this regard, the second output signal provides the current state of the LC material following external influences. Notably, the second output signal facilitates ongoing monitoring and adjustment of properties of the LC material over time. The term *"second instant time"* refers to another specific moment or point in time subsequent to the first time instant. The second time instant occurs when the second input signal is applied to the test circuit, initiating another phase of measurement or assessment of the LC material. The term *"test peak voltage"* refers to a maximum voltage level observed in the second output signal during the second time instant. Notably, the test peak voltage is an essential metric used to quantify changes in the capacitance of the mesogens.

Optionally, the input signal is any one of: an impulse voltage signal, a step voltage signal, a ramp voltage signal. In this regard, the term *"impulse voltage signal"* refers to a sudden and brief electrical signal characterized by its rapid rise and fall times. The impulse voltage signal can be used to trigger a rapid response in the LC material, measuring how quickly the LC material can change its properties in response to an abrupt input. Herein, by analysing the peak voltage achieved during the abrupt input, the at least one processor can determine an intrinsic switching speed of the mesogens and detect any slowing that indicates the ageing of the mesogens and/or degradation of the alignment material the term *"step voltage signal"* refers to a sudden change in voltage amplitude from one constant level to another, typically within a very short timeframe. It will be appreciated that the step voltage signal facilitates assessment of steady-state behaviour of the LC material under sustained electrical conditions. By applying the step voltage signal as the input signal, the at least one processor can evaluate how effectively the LC material maintains its properties over extended periods, offering valuable insights into long-term stability and performance characteristics. Herein, by comparing the reference peak voltage under the step voltage signal with a successive reference peak voltage, the at least one processor is able to detect the variation in the capacitance of the mesogens that directly correspond to the ageing of the mesogens and/or the production variance.

Moreover, the term *"ramp voltage signal"* refers to an electrical signal characterized by a gradual and continuous increase or decrease in voltage over time, with a controlled rate of change. The ramp voltage signal is employed to assess the time-dependent response of the LC materials to slowly varying electrical inputs, helping to characterize the dynamic behaviour and response times. When the input signal is the ramp voltage signal, the ramp rate is a multiple of RCR constant to accurately ascertain the response. It will be appreciated that the ramp voltage signal enables precise assessment of how the LC material reacts to gradual changes in voltage. It will be appreciated that the ramp voltage signal is useful in determining a threshold voltage at which alignment of the mesogens begins. When such alignment changes over multiple test instants, the at least one processor is able to predict degradation in the state of the mesogens.

A technical effect of the input signal being any one of: the impulse voltage signal, the step voltage signal, the ramp voltage signal, is that it enables comprehensive characterization of the response dynamics of the LC materials to different electrical inputs. Another technical effect of the input signal being any one of: the impulse voltage signal, the step voltage signal, the ramp voltage signal, is that it provides a complementary diagnostic framework, wherein the impulse voltage provides information regarding a transient respond speed, the step voltage signal provides information regarding steady-state stability of the mesogens, and the ramp voltage signal provides information regarding threshold behaviour of the mesogens.

Throughout the present disclosure, the term *"capacitance"* refers to an ability of the mesogens within the LC material to store electrical charge. Typically, capacitance is measured in microfarads (µF), nanofarad (nF), picofarad (pF). Moreover, the capacitance is influenced by the state of the mesogens and optionally the orientation, which changes in response to the electric field applied by the first electrode and the second electrode. Herein, analysing the difference between the reference peak voltage and the test peak voltage, the variation in the capacitance of the mesogens is determined. This variation reflects changes in the state or orientation of the mesogens due to factors such as environmental conditions or ageing. It will be appreciated that by continuously monitoring the variation in the capacitance of the mesogens, the at least one processor is configured to identify and respond to environmental influences or signs of material degradation. This capability enables timely adjustments and interventions hence enhances durability and longevity of the LC material. The decrease in the capacitance of the mesogens could be due to the prolonged exposure to high temperatures, which may have caused the mesogens to align differently or degrade over time. Thereby, detecting this change, the at least one processor is configured to optionally alert a user to potential performance issues or need for maintenance hence ensuring the reliability and longevity of the optical element. In a first example, the optical element integrated into the optical unit may be operating in a high-temperature environment of 50 degrees Celsius (°C) for an extended period. Initially, at the first time instant, the reference peak voltage measured and recorded may be 1.5 volt (V) under standard temperature of 25°C. After some time, at the second time instant, the second input signal is applied, and the test peak voltage measured may be 1.2V after prolonged exposure to high temperature of 50°C. In this regard, the test peak voltage is significantly lower than the reference peak voltage, thereby indicating a decrease in the capacitance of the mesogens.

Throughout the present disclosure, the term *"state of the mesogens"* refers to at least one of: an orientation, a condition of molecules within the LC material. The state of the mesogens is influenced by factors such as the temperature, the electric field, and ageing, and it directly affects optical properties of the LC material (for example, such as refractive index, light transmission characteristics and the like). Herein, the state of the mesogens at the second time instant is determined by analysing the variation in the capacitance of the mesogens between the first time instant and the second time instant. Changes in the capacitance indicate alterations in the orientation or alignment of the mesogens. The process involves mapping the measured capacitance variation to known states or conditions of the mesogens, which can reflect factors such as temperature changes, the external electric field, or ageing effects. It will be appreciated that precise and timely detection of changes in the state of the mesogens facilitates immediate corrective actions to maintain optical quality of the LC material. Continuing with the first example, the capacitance decreases significantly between the first time instant and the second time instant, indicates that the mesogens are becoming less aligned, possibly due to environmental factors such as increased temperature. Thereby, determining the variation in the capacitance, the at least one processor can adjust the electric fields applied by the first electrode and the second electrode to re-align the mesogens and restore the desired optical properties. Beneficially, unlike conventional LC devices which apply the drive signal reactively or at fixed pre-calibrated levels, the at least one processor applies the drive signal in a predictive manner, wherein variation in the reference peak voltage and the test peak voltage is extrapolated to anticipate degradation trends before visual artefacts occur. This allows proactive adjustment of the at least one driving parameter to preserve optical performance.

Optionally, the state of the mesogens comprises at least one of: an orientation, a polarity, a rotation per unit voltage, of the mesogens. In this regard, the term *"orientation of the mesogens"* refers to an alignment of mesogenic molecules within the LC material relative to a specified surface. It will be appreciated that determining the orientation of the mesogens enables for precise control over optical properties such as birefringence and polarization in the LC material. This control is essential for achieving high-resolution displays with minimal optical aberrations and maximizing light transmission efficiency. In this regard, the orientation could be derived by mapping the variation in a capacitance of the mesogens to pre-stored birefringence-capacitance calibration curves, enabling quantitative determination of alignment angles.

Moreover, the term *"polarity of the mesogens"* refers to an alignment of molecular dipoles within the LC material. The polarity of the mesogens indicates orientation of dipole moments of the mesogens relative to an external reference, typically influenced by the electric field applied. In this regard, the polarity could be derived by applying alternating input signals and observing phase-dependent changes in the capacitance of the mesogens, where a reversal in dipole orientation yields a measurable inversion in the capacitance response.

The term *"rotation per unit voltage"* refers to an angular displacement experienced by the mesogens within the LC material per unit of applied voltage wherein such angular displacement is often expressed in degrees per volt (°/V) or radians per volt (rad/V). Specifically, the rotation per unit voltage of the mesogens characterizes electro-optical response of the LC material, influencing its optical properties such as polarization and light transmission. It will be appreciated that a higher rotation per unit voltage signifies enhanced responsiveness of the LC material to the electric fields applied, enabling faster switching speeds for display applications. In this regard, the rotation per unit voltage could be determined by incrementally varying the input signal and calculating a slope of the capacitance-voltage response, such that values when the slope is reducing over successive measurements indicate mesogen ageing. The precise measurement of the rotation per unit voltage facilitates design of energy-efficient displays with reduced power consumption.

In this regard, there is explicit characterization of the state of the mesogens in terms of the at least one of: the orientation, the polarity, the rotation per unit voltage, of the mesogens. Each of these are diagnostic dimensions that provide distinct physical insights into behaviour of the mesogens. These mappings explicitly link electrical measurements (i.e., the capacitance variation) to physical states of the mesogens, thereby ensuring enablement of the claimed features. In one example, when the state of the mesogens may comprise the orientation, this may be mapped to a change in a birefringence of the LC material, which may indicate optical distortion or misalignment. In another example, when the state of mesogens may comprise the polarity, it allows detection of instability in molecules of the mesogens, which may otherwise leads to reduced optical efficiency over time. In yet another example, when the state of the mesogens comprise the rotation per unit voltage, an electro-optical responsiveness of the mesogens may be quantified. Herein, when the rotation per unit voltage reduces over successive measurements, it may indicate an ageing of the LC material.

A technical effect of the aforementioned feature is that by monitoring the state of the mesogens such as the orientation, the polarity, and/or the rotation per unit voltage, the optical unit can achieve precise modulation of light polarization, transmission characteristics, and overall display performance. Another technical effect is that the state of mesogens comprising the the at least one of: the orientation, the polarity, the rotation per unit voltage, of the mesogens, allows the processor to differentiate between different modes of degradation. Such diagnostic granularity enables predictive compensation of drive signals. Advantageously, this creates a synergistic feedback mechanism in which capacitance-based electrical sensing directly informs optical control of the optical element, wherein the optical element is controlled in an adaptive manner.

Throughout the present disclosure, the *"drive signal"* refers to an electrical signal that is applied to the first electrode, the second electrode within the optical unit to induce a specific response. The term *"driving parameter"* refers to a specific parameter within the drive signal that can be adjusted to control operation of the optical element. Adjusting the at least one driving parameter affects how the LC material responds hence influences optical properties such as polarization, transmission, or refractive index of the optical element. Herein, the adjustment involves analysing the second output signal from the test circuit, which reflects the current state of the mesogens. Based on this analysis, the at least one driving parameter of the drive signal is dynamically adjusted. This adjustment optimizes the electric field applied to the first electrode and the second electrode, precisely controlling the orientation and alignment of the mesogens within the LC material. Hence, changes in the at least one optical parameter of the optical element, such as polarization direction, transmission characteristics, refractive index, and similar are achieved. This adaptive control ensures optimal optical performance adjusted to environmental conditions or specific operational requirements. A technical effect of such a closed loop arrangement is that it transforms the LC material into a self-sensing and a self-compensating element, which allows predictive maintenance and/or extended material longevity.

Optionally, the at least one driving parameter comprises at least one of: an amplitude, a frequency, of the drive signal. In this regard, the term *"amplitude"* refers to a magnitude or a peak value of the drive signal (namely, a voltage signal) applied to the first electrode and the second electrode in the optical unit. The amplitude represents maximum voltage or maximum current level that the drive signal reaches, which directly affects the strength of the electric field applied on the LC material. Herein, adjusting the amplitude modulates an intensity of the electric field, thereby influencing the alignment and orientation of the mesogens within the LC material. Higher amplitude can induce a stronger electric field, causing a more pronounced reorientation of the mesogens. Conversely, a lower amplitude results in a weaker electric field, causing a subtler reorientation of the mesogens. It will be appreciated that adjusting the amplitude of the drive signal provides precise control over the strength of the electric field, enabling fine-tuning of optical properties of the LC material for optimal performance in various applications. For example, if an initial amplitude of the drive signal may be 5 volts. Then, to achieve a significant alignment of the mesogens, the amplitude may be increased to 10 volts. This change may cause the mesogens to align more strictly along electric field lines.

The term *"frequency"* refers to a number of oscillations per unit time of the drive signal applied to the first electrode and the second electrode in the optical unit. Typically, the frequency is measured in hertz (Hz). Herein, adjusting the frequency of the drive signal alters a temporal response of the mesogens, such that higher frequencies accelerate molecular reorientation for faster optical switching, while lower frequencies stabilise mesogen alignment for sustained optical states.

It will be appreciated that the at least one processor is not limited to selecting fixed amplitude and fixed frequency values but is configured to dynamically adapt the at least one driving parameter based on diagnostic measurements of the state of the mesogens, including the variation in capacitance, the reference peak voltage, and the test peak voltage. For example, when ageing of the mesogens may be detected through a reduction in capacitance, the at least one processor may increase the amplitude to ensure sufficient reorientation of the mesogens. Similarly, when a delay in response speed may be detected from frequency response analysis, the at least one processor may adjust the frequency to restore responsiveness.

A technical effect of the at least one driving parameter comprising at least one of: the amplitude, the frequency, of the drive signal is that adaptive control variables are used for controlling the mesogens. This synergy ensures predictive compensation for at least one of: the ageing of the mesogens, the alignment material ageing, the production variance, thus maintaining stable optical performance of the optical unit under varying operating and environmental conditions.

Optionally, the at least one optical parameter comprises at least one of: at least one optical power to be produced, a position of at least one region of the optical element in which the at least one optical power is to be produced, a profile of the optical element, a transparency of at least a portion of the optical element, an operational mode of the optical element. In this regard, in some implementations, the at least one optical power to be produced comprises a single optical power. In other implementations, the at least one optical power to be produced comprises a plurality of optical powers. It will be appreciated that the plurality of optical powers could be produced in different regions of the optical element at a same time, for example, for enabling the user to focus on distant objects (using a negative optical power or a zero optical power, depending on the user's need) and to focus on near objects (using a zero optical power or a positive optical power, depending on the user's need). Optionally, in this regard, the at least one optical power is at least one of: the positive optical power, the negative optical power, the zero optical power. Herein, the positive optical power is used for reading or focusing on nearby objects, when the user has hypermetropia or presbyopia. The negative optical power is used for distance viewing, when the user has myopia. The zero optical power may be used when the user does not have myopia and needs to focus on distant objects, or when the user does not have hypermetropia or presbyopia and needs to focus on nearby objects. Thus, the at least one driving parameter of the drive signal is adjusted to control the first electrode, the second electrode, thereby modifies the alignment and resulting optical power of the LC material. In particular, the at least one processor dynamically selects and adjusts the at least one optical power based on the state of the mesogens, which compensates for ageing of the mesogens or, optionally, a thermal drift in real time or near-real time.

Optionally, the at least one optical parameter comprises the position of the at least one region in which the at least one optical power is to be produced. In an example, the at least one region of the active optical element may comprise a central region and a peripheral region surrounding the central region. The central region may be in a form of a single portion having a first adjustable optical power, wherein the first adjustable optical power may be one of: a zero optical power, a negative optical power (depending on the user's need). In some cases, the peripheral region may have a plurality of portions having adjustable optical powers, wherein the optical power of a given portion of the peripheral region is to be selectively adjusted to produce a given optical power. The plurality of portions may be sparsely arranged in the peripheral region to cover different portions of the peripheral region. In some other cases, the peripheral region may also be in a form of a single portion that is continuous. In such a case, a given part of the single portion could be selectively controlled to produce a given optical power at the given part of the single portion. As an example, when the first adjustable optical power is the zero optical power, the given optical power could be a positive optical power. As another example, when a user is looking through, for example, a left portion of the peripheral region, the optical power may be required to be produced only on the left portion. Furthermore, the optical element may also comprise an intermediate region between the central region and the peripheral region, wherein the intermediate region has an intermediate optical power that lies in between adjustable optical power and an optical power of the peripheral region. This enables in providing a smooth transition of optical powers in the optical element. Moreover, the at least one processor ensures that the alignment material ageing or optionally local degradation does not compromise global optical uniformity of the optical element.

Optionally, the profile of the optical element is a function that is indicative of how one or more of: a focal length, a distortion, a chromatic aberration, vary across the optical element. In other words, the profile of the optical element is an impact that said optical element has to a light wavefront that is passing through. Herein, the at least one processor updates the profile of the optical element by adjusting the at least one drive parameters in response to measured variations in the capacitance of the mesogens, thereby maintaining a consistent focal length and minimizing aberrations despite long-term ageing of the mesogens.

It will be appreciated that the transparency within the optical element may not be same throughout the optical element. This means that a given portion of the optical element may be fully transparent, while another portion of the optical element may be translucent (i.e., partially transparent) or even opaque (i.e., not transparent). Optionally, the transparency of at least the portion of the optical element depends on an intensity of external light which would pass through said portion to be incident on the user's eyes. For example, when the intensity of the external light along the gaze direction of the user is extremely high (for example, such as in case of an incoming glare of car headlamps, a direct glare of the sun, reflections of sunlight from a surface of a sea, reflections of sunlight from a surface of snow, and similar), at least the portion of the optical element through which such light would pass is made translucent or opaque. This dynamic control helps to mitigate glare and optimize visibility in varying lighting conditions. In this regard, the dynamic control is provided based on the intensity of the external light, as well as the state of the mesogens, thus ensuring that modulation of the optical element remains reliable even as at least one property of the LC material changes due to the ageing of the mesogens and/or temperature effects.

Optionally, the operational mode of the optical element defines an active state or a passive state of the optical element, controlling its response to different environmental conditions or user inputs. For example, in an adaptive eyewear application, the optical element can switch between the active state, where it dynamically adjusts the focus based on the user's gaze direction, and the passive state, where it maintains a fixed optical power. In the active state, the at least one processor detects the state of the mesogens and adjust the optical power in the corresponding region of the optical element to enhance vision for near or far objects. In contrast, in the passive state, the optical element maintains a preset optical power suitable for general use without responding to alignment of the mesogens. It will be appreciated that adjusting the active state or the passive state for the operational mode of the optical element, based on the state of the mesogens, enables for precise and energy-efficient adjustments to visual needs of the user, improving visual performance and comfort under varying conditions. Herein, such state-driven switching, ensures that the operational mode is selected in an adaptive manner than being a static configuration.

A technical effect of the at least one optical parameter is the ability to dynamically adjust the at least one optical parameter across different regions of the optical element. This enables customized optical performance adjusted to specific needs of the user and environmental conditions, enhancing versatility and usability in various applications. Another technical effect of the at least one optical parameter is that information regarding said at least one optical parameter is received directly by monitoring of the state of the mesogens, thereby enabling predictive compensation of the drive signal and stable optical performance over an operational lifetime of the optical unit.

Optionally, the at least one processor is further configured to determine at least one of: a temperature of the mesogens at the second time instant, an ageing of the mesogens, an alignment material ageing, a production variance of the mesogens, based on the state of the mesogens. In this regard, the at least one processor is configured to measure the capacitance of the mesogens at the second time instant by analysing the second output signal. Thereafter, the measured capacitance is compared with pre-stored reference data that correlates capacitance values with specific temperatures for the same type of the mesogens. Based on this comparison, the current temperature of the mesogens is determined. It will be appreciated that accurate determination of the temperature of the mesogen enables real-time monitoring and adjustment, ensuring optimal performance and preventing thermal degradation of the LC material. For example, the capacitance measured may be 3 pF at the second time instant, and the reference data may indicate that the capacitance of 3 pF corresponds to a temperature of 40°C. Then, the temperature of the mesogens may be inferred to be 40°C.

Herein, the term *"ageing"* refers to alteration or degradation of the mesogen. The at least one processor quantifies the extent of ageing by comparing current capacitance values with initial values for mesogens that have not degraded. Additionally, the at least one processor is configured to monitor long-term trends in the variation of the capacitance across multiple successive test peak voltages, wherein reduction in capacitance response over time is classified as the ageing of the mesogens. It will be appreciated that detecting the ageing of the mesogens allows for timely maintenance or replacement hence extending longevity and reliability of the optical unit. For example, over a period of time the capacitance of the mesogens may decrease from 3 pF to 2.8 pF. Then, the decrease in the capacitance may be identified as a sign of the ageing of the mesogens due to consistent degradation in the capacitance. Beneficially, the at least one processor is configured to identify absolute changes in values of the capacitance, as well as to extrapolate temporal trends, thereby predicting onset of the ageing of the mesogens before it manifests as a visual distortion.

Furthermore, optionally, the at least one processor is configured to monitor stability of the capacitance readings over time. In this regard, the at least one processor may detect inconsistencies in the capacitance that cannot be attributed solely to the mesogens. Thereafter, these inconsistencies are correlated with known ageing effects of the alignment material. Moreover, the at least one processor detects the alignment material ageing by monitoring a differential lag between the reference peak voltage and the test peak voltage. For example, there may be an increased lag in the variation of capacitance between the reference peak voltage and the test peak voltage, as compared to the reference data, that may be indicative of the alignment material ageing. It will be appreciated that identifying the alignment material ageing enables targeted interventions to maintain alignment accuracy, improving overall display quality and performance.

Furthermore, optionally, the at least one processor may utilize initial capacitance measurements of the mesogens, assuming ideal production standards. The at least one processor continuously compares current capacitance readings with the initial capacitance values and standard production variance data. In this regard, if the at least one processor detects any significant deviations from the standard production values, indicates production variance of the mesogens. For example, there may be a predetermined tolerance band to determine the production variance. When the deviations exceed the predetermined tolerance band, such deviations may be indicative of the production variance. It will be appreciated that detecting the production variances of the mesogens ensures consistent quality and performance of the optical unit by enabling quality control measures during manufacturing. For example, if an initial calibrated capacitance may be 3 pF, but subsequent groups of the mesogens show capacitance values ranging between 2.7 pF and 3.3 pF. The at least one processor then identifies the range of 2.7 pF and 3.3 pF as indicative of the production variance of the mesogens.

A technical effect of determining the at least one of: the temperature of the mesogens, the ageing of the mesogens, the alignment material ageing, the production variance of the mesogens, based on the state of the mesogens is that the at least one processor can provide real-time feedback for maintaining optimal operation. Another technical effect of determining the at least one of: the temperature of the mesogens at the second time instant, the ageing of the mesogens, the alignment material ageing, the production variance of the mesogens, based on the state of the mesogens, is that it introduces a precise, time-differentiated, capacitance-based diagnostic mechanism. This capacitance-based diagnostic mechanism uses the LC material as an electrically modelled capacitor formed by the LC material. Moreover, the capacitance-based diagnostic mechanism detects changes in the state of the mesogen that arise due to thermal drift, ageing, or manufacturing deviation. Advantageously, the detection is achieved via temporal, time-resolved comparison of the reference peak voltage and the test peak voltage, thereby synergistically deriving physical parameters of the mesogens from the variation in capacitance rather than from external or static sensing.

Optionally, the optical unit further comprising at least one temperature sensor, wherein when determining the temperature of the mesogens at the second time instant, the at least one processor is further configured to:
receive a sensor data from the at least one temperature sensor, wherein the sensor data comprises values related to ambient temperature of the optical unit; and
process the sensor data to estimate the temperature of the mesogens at the second time instant.

In this regard, the term *"sensor data"* refers to real-time readings of the surrounding environment of the optical unit. The term *"ambient temperature"* refers to a temperature of a surrounding environment in which the optical unit operates, which can influence the behaviour of the mesogens. Herein, the at least one temperature sensor collects the ambient temperature data surrounding the optical unit. The sensor data is received by the at least one processor which is configured to process the sensor data, in order to estimate the temperature of the mesogens at the second time instant. In particular, the at least one processor is configured to correlate values of the ambient temperature with temperature data of the mesogens derived from the capacitance, wherein the temperature data of the mesogens is obtained from a comparison between the reference peak voltage and the test peak voltage.

Moreover, this estimation could involve correlating the ambient temperature with thermal properties of the LC material, which enables the at least one processor to estimate the temperature of the mesogens. Optionally, the temperature of the mesogens at the second time instant is estimated by correlating the values related to the ambient temperature of the optical unit to the temperature of the mesogens. Advantageously, the at least one processor could apply compensation factors to account for thermal lag between the ambient temperature and the LC material, thus ensuring that the estimated temperature of the mesogens reflects actual molecular conditions rather than solely external readings.

It will be appreciated that this temperature estimation improves the accuracy of determining the state of the mesogens, allowing for precise adjustments to the performance of the optical element based on environmental conditions. Furthermore, by combining sensor-based measurements of the ambient temperature with the state of the mesogens, a hybrid estimation is achieved that is robust against drift, noise, or sudden environmental fluctuations. This estimation is then used to assess the state of the mesogens and adjust the driving parameters of the optical element, to ensure that the user has a comfortable viewing experience, when the optical unit is in use.

A technical effect of determining the temperature of the mesogens in such a manner is that it enables accurate control of the performance of the optical unit by ensuring the state of the mesogens is reliably determined, even under dynamic ambient temperature conditions. Another technical effect of determining the temperature of the mesogens in such a manner is that this hybrid approach differentiates the optical unit from conventional optical units that rely solely on external temperature sensors, by providing self-calibration that integrates both the sensor data comprising values related to the ambient temperature of the optical unit and temporal peak-voltage comparison.

Optionally, the optical unit further comprises a frame employed to hold the optical element, wherein the frame has the at least one temperature sensor embedded therein, the at least one temperature sensor being arranged at at least one of:
a first predefined distance from an edge at which the optical element interfaces with the frame, wherein the first predefined distance lies in a range of 1 millimetre to 3 millimetres;
a second predefined distance from a centre of the optical element, wherein the second predefined distance lies in a range of 20 millimetres to 30 millimetres.

In this regard, the term *"frame"* refers to a mechanical component that serves as a supporting and enclosing apparatus for the optical element within the optical unit. The frame is typically designed to securely hold the optical element in position while providing mechanical stability and protection from external influences. The term *"first predefined distance"* refers to a predetermined measurement that is set within a defined range from the edge at which the optical element interfaces with the frame. The first predefined distance may, for example, lie in a range from 1 millimetre, 1.2, 1.3, 1.5, 1.7, 1.9, 2.2, 2.5, or 2.8 millimetres up to 1.4, 1.8, 2.1, 2.4, 2.7, 2.9, or 3 millimetres. The term *"second predefined distance"* refers to another predetermined measurement that is set within a defined range from the centre of the optical element. The second predefined distance may, for example, lie in a range from 20, 20.5, 21, 21.5, 23, 24.5, 26, or 28 millimetres up to 22, 25, 27, 28, 28.5, 29, or 30 millimetres.

It will be appreciated that arranging the at least one temperature sensor at the at least one of: the first predefined distance, the second predefined distance enhances the accuracy of temperature measurements at critical interface. Herein, a placement of the at least one temperature sensor at the first predefined distance enables the at least one processor to monitor thermal transfer at the interface between the frame and the optical element, where influence of the ambient temperature is most prominent. Moreover, placement of the at least one temperature sensor at the second predefined distance enables the at least one processor to capture internal heating effects within the optical element that predominantly arise from the drive signal to drive at least one of: the at least one first electrode, the at least one second electrode.

Hence, this precise placement minimizes influence of the fluctuations in the ambient temperature while capturing localized thermal variations that may arise from heat generated or absorbed by the optical element during operation. By processing data from both positions of the at least one sensor, the at least one processor can generate a temperature gradient profile across the optical element and correlate it with variation in the capacitance derived from the reference peak voltage and the test peak voltage. Therefore, processing the data from both positions of the at least one sensor ensures robust estimation of the temperature of the mesogens.

Consequently, this configuration enables effective monitoring and control of the performance of the optical element. A technical effect of the aforementioned feature is that the strategic placement of the at least one temperature sensor at the first predefined distance and/or the second predefined distance enhances the accuracy of temperature readings at critical locations, enabling effective monitoring and control of the optical element's thermal performance.

In an embodiment, when determining at least one of: the ageing of the mesogens, the alignment material ageing, the production variance of the mesogens, the at least one processor is further configured to:
apply plurality of reference input signals to the test circuit to measure plurality of reference output signals at a third time instant, each of the plurality of reference output signals corresponds to each of the plurality of reference input signals;
apply plurality of test input signals to the test circuit to measure plurality of test output signals at a fourth time instant, each of the plurality of test input signals corresponds to each of the plurality of test output signals; and
determine a given test input signal at which at least one property of the mesogens changes, by comparing each of the plurality of test output signals with corresponding reference output signal from amongst the plurality of reference output signals, wherein the given test input signal is determined to be a threshold voltage.

In this regard, the term *"reference input signals"* refers to a set of predetermined electrical signals, usually an alternating current (AC) voltage that are applied to the test circuit at the third time instant to establish baseline measurements. The plurality of reference input signals are used to obtain the plurality of reference output signals which serves as a standard for comparison with the plurality of test output signals. The term *"test input signals"* refers to a set of electrical signals, applied to the test circuit at the fourth time instant. The term *"given test input signal"* refers to a specific electrical signal from the plurality of test input signals that causes a significant change in the at least one property of the mesogens. Optionally, the at least one property comprises at least one of: the variation in capacitance of the mesogens, optical transmission property, electrical property. Notably, the given test input signal is identified by comparing each of the test output signals with the reference output signals and is used to determine the threshold voltage. Herein, the term *"threshold voltage"* refers to a particular voltage level of the test input signal at which a significant change in the at least one property of the mesogens is observed, indicating a transition or a specific condition of the mesogens. Herein, the at least one processor applies the plurality of the reference input signals at the third time instant. The plurality of reference input signals are used to establish baseline measurements of properties of the mesogens (for example, such as capacitance, an optical transmission, an electrical property, and similar) under known conditions. The capacitance of the LC material is influenced by the ability of molecules of the mesogens to rotate in response to an electric field. This rotational capability alters the capacitance of the measured circuit. However, the LC material exhibits a minimum electric field, known as the threshold voltage, below which the capacitance remains constant. Above the threshold voltage, changes in the electric field affect the capacitance by modulating the alignment of molecules of the mesogens. It will be appreciated that precise monitoring and comparison of plurality of the reference input signals, and plurality of the test input signals enables early detection of the ageing of the mesogens hence ensures timely maintenance and optimal performance of the optical element. Furthermore, progressive drift of the threshold voltage beyond a predetermined tolerance is classified by the at least one processor as a sign of alignment layer wear or production-related deviations, thereby providing predictive diagnostic information rather than merely reactive detection.

It will be also appreciated that dynamic feedback based on plurality of the reference output signals and plurality of the test output signals supports adaptive operation, accommodating environmental changes and extending the longevity of the optical element. Furthermore, it will be appreciated that the threshold voltage enables proactive adjustments to optimize alignment and the optical properties of the mesogens enhance performance stability.

For example, the at least one processor may be configured to apply the plurality of reference input signals of 1V, 2V, 3V, and 4V to the test circuit and measure the plurality of reference output signals at the third time instant. In this regard, the plurality of reference output signals may be 0.8V, 1.5V, 2.2V, and 2.8V, respectively, for each of the plurality of reference input signals. Then, the at least one processor may be configured to apply the plurality of test input signals of 1V, 2V, 3V, and 4V to the test circuit and measure the plurality of test output signals at the fourth time instant. In this regard, the plurality of test output signals may be 0.7V, 1.4V, 2.0V, and 2.6V, respectively, for each of the plurality of test input signals. Then, the at least one processor compares each test output signal with corresponding reference output signal. This comparison helps to identify any changes or deviations in the at least one property of the mesogens. In this regard, the at least one processor may compare 0.7V with 0.8V, 1.4V with 1.5V, 2.0V with 2.2V, and 2.6V with 2.8V. It may be observed that there is a significant deviation when the reference input signal may be 3V. Hence, this 3V may be identified as the threshold voltage.

A technical effect of the determination of the threshold voltage in such a manner is that it enables precise determination of changes in the at least one property of the mesogens by comparing the plurality of reference input signals and the plurality of test input signals. Another technical effect of the determination of threshold voltage in such a manner is that it enables predictive diagnostics of mesogen degradation, alignment material ageing, and production variance, thereby ensuring adaptive control of the drive signals and stable long-term performance of the optical element.

In another embodiment, when determining at least one of: the ageing of the mesogens, the alignment material ageing, the production variance of the mesogens, the at least one processor is further configured to:
apply plurality of reference input frequency signals to the test circuit to measure plurality of reference output frequency signals, each of the plurality of reference input frequency signals corresponds to each of the plurality of reference output frequency signals, to determine plurality of reference time instants taken to achieve the plurality of reference frequency responses;
apply plurality of test frequencies to the test circuit to measure plurality of test frequency responses, each of the plurality of test frequencies being corresponding to each of the plurality of test frequency responses, to determine plurality of test time instants taken to achieve the plurality of test frequency responses; and
determine a given test time instant at which a response speed of the liquid crystal material changes in response to a given frequency, by comparing each of the plurality of test frequency response to corresponding reference frequency response from amongst the plurality of reference frequency responses.

In this regard, the term *"reference input frequency signals"* refers to predetermined electrical signals, typically AC signals, applied to the test circuit during calibration or baseline measurement phases. The reference input frequency signals cover a range of frequencies known to affect the performance of the LC material in the optical unit. Each signal within the plurality of the reference input frequency signals represents a specific frequency within defined range. Herein, the plurality of the test frequencies covers a range of frequencies, typically overlapping with those used for reference inputs, to ensure comprehensive testing of response of the LC material across different frequency bands. The at least one processor applies plurality of the reference input frequency signals, for example, such as 1 kilohertz (kHz), 2 kHz, 5 kHz, and so forth, to the test circuit. A comparison between the plurality of reference frequency responses and the plurality of test frequency responses enables the at least one processor to identify frequency-dependent drift in response speed, which is indicative of mesogen ageing, alignment material ageing, or production variance. It will be appreciated that determining the given test time instant at which the response speed of the LC material changes is used to maintain consistent quality and performance during production, ensuring reliability across manufactured units.

In a second example, the optical unit may require testing in frequencies ranging from 1 kHz to 10 kHz. The at least one processor may be configured to apply 2 kHz and 5 kHz to the test circuit, and determine plurality of reference time instants taken to achieve the plurality of reference frequency responses. When the reference input signal of 2 kHz may be applied, the at least one processor then measures the output frequency response that may be 1.8 kHz. Then, the at least one processor may be configured to apply the plurality of test frequencies of 4 kHz and 7 kHz and determine the plurality of test time instants taken to achieve the plurality of test frequency responses. In this regard, the output frequency response generated may be 3.7 kHz and 4.3 kHz, respectively. Upon comparing each test frequency response with the corresponding reference frequency response, any variations in the response speed of the LC material at different frequencies are identified. If the reference output frequency response at 2 kHz was 2.0 kHz and the test output frequency response at the same frequency may be 1.9 kHz, that means there is a slight decrease in the response speed of the LC material. Hence, the at least one processor can effectively determine how the ageing of the mesogens, the alignment material ageing, the production variance of the mesogens affect the dynamic response of the LC material across various frequencies. In particular, a systematic delay at higher test frequencies relative to the reference input frequency signals is classified as the ageing of the mesogens, while non-uniform frequency shifts across different regions of the optical element are classified as the production variance. Moreover, a consistent reduction in response speed across all test frequencies is classified as the alignment material ageing.

A technical effect of the aforementioned frequency sweep analysis is that it enables precise determination of the response speed of the LC material to varying frequencies. Another technical effect is that by performing temporal comparison of the plurality of reference time instants and the plurality of test time instants, the at least one processor establishes a predictive diagnostic framework that allows proactive adjustment of the at least one drive parameter before observable optical degradation occurs.

In yet another embodiment, the test circuit is incorporated into a Wheatstone bridge configuration, said Wheatstone bridge configuration comprising:
a first arm comprising the test circuit that is arranged between a first node and a second node, the first resistor being connected to the first node and the second resistor being connected to the second node, wherein the second node is connected to a power source;
   a second arm comprising a first capacitor arranged between the second node and a third node;
   a third arm comprising a second capacitor arranged between the first node and a fourth node, wherein the fourth node is connected to an electrical ground; and
   a fourth arm comprising a third capacitor arranged between the third node and the fourth node,
wherein a data processing unit is arranged between the first node and the third node,
wherein when determining at least one of: the ageing of the mesogens, the alignment material ageing, the production variance of the mesogens, the at least one processor is further configured to:
   apply a third input signal at the second node to determine a first operational point, wherein a third output signal corresponding to the third input signal is measured by the data processing unit;
   apply a fourth input signal at the second node to determine a second operational point, wherein a fourth output signal corresponding to the fourth input signal is measured by the data processing unit;
   compare the third output signal and the fourth output signal to determine a variation of capacitance between the first operational point and the second operational point; and
   when the variation of capacitance between the first operational point and the second operational point exceeds a predefined threshold, identify that there is at least one of: the ageing of the mesogens, the alignment material ageing, the production variance of the mesogens.

In this regard, the term *"Wheatstone bridge configuration"* refers to an electrical circuit used to measure an unknown electrical resistance or capacitance. Typically, the Wheatstone bridge configuration comprises four arms that are arranged in a rhombus shape. One of the arms comprises the test circuit, while the other arms comprise known reference capacitors. When the Wheatstone bridge configuration is balanced, voltage difference at output of said Wheatstone bridge configuration is zero. Any imbalance in the bridge (detected as a voltage difference) is indicative of a change in the test component. The term *"data processing unit"* refers to an electronic component responsible for receiving, processing, and analysing input data to derive control signals. Optionally, the data processing unit comprises an analog-to-digital converter (ADC). The term *"operational point"* refers to at least one of: an applied voltage, a temperature, a frequency, or other parameters that influence the state of the mesogens. The term *"predefined threshold"* refers to a specific value of the mesogens that represents acceptable limits of variation in capacitance measurements.

Herein, the ageing of material, particularly the LC material, can be determined using the Wheatstone bridge configuration via differential measurements. The configuration enables precise comparisons between two operating points (i.e., two different input signals). The first capacitor, the second capacitor, and the third capacitor in the Wheatstone bridge configuration helps to establish a balanced reference system to detect capacitance changes in the test circuit, which relates to the at least one of: the ageing of the mesogens, the alignment material ageing, the production variance of the mesogens. Notably, the first capacitor (in the second arm) and the second capacitor (in the third arm) serve as reference components that create symmetry in the Wheatstone bridge configuration, while the third capacitor (in the fourth arm) stabilizes the test circuit. When the capacitance of the test circuit changes due to the ageing of the mesogen or other factors, it disrupts the balance of the Wheatstone bridge configuration, and the data processing unit detects resulting output signal differences, allowing the at least one processor to identify those variations.

A particular advantage of incorporating the test circuit into the Wheatstone bridge configuration is that even minute variations in the capacitance of the mesogens create measurable imbalances, amplifying sensitivity beyond direct capacitance measurements. The at least one processor uses this enhanced sensitivity to detect early-stage mesogen ageing, subtle alignment material degradation, and production-induced inconsistencies that would otherwise remain undetected.

In this regard, when the third input signal is applied by the at least one processor at the second node, the test circuit's capacitance is compared to the reference capacitors, and the output signal is measured by the data processing unit at the first node and the third node. By applying two different input signals (namely, the third input signal and the fourth input signal), the first and second operational points are established. Herein, the input signal is any one of: a voltage signal, a current signal. The output signals corresponding to these two operational points are compared by the data processing unit. This process detects subtle differences in capacitance caused by changes in the properties of the LC material, enabling identification of degradation or manufacturing inconsistencies of the LC material. Optionally, besides the variation in the capacitance, there is variation in impedance or in response time, indicating the ageing or the production variance of the mesogens.

A technical effect of utilising the Wheatstone bridge configuration enables precise detection of variations in the capacitance of the mesogens by providing a balanced reference system. Another technical effect is that an architecture of the balanced Wheatstone bridge inherently suppresses external noise and environmental disturbances, ensuring that the detected signal variations are attributable specifically to changes in the state of the mesogens.

Optionally, when the optical element is divided into a plurality of zones, the test circuit in a given zone comprises a fraction of the first resistor, a fraction of the second resistor, and a fraction of the test capacitor, wherein the fraction of the first resistor and the fraction of the second resistor correspond to a fraction of a total length of the trace of the first electrode and the at least one second electrode, respectively, and the fraction of the test capacitor corresponds to an area of the liquid crystal material,
wherein the test circuit is embedded in any one of: the at least one first electrode, the at least one second electrode, corresponding to at least one zone from amongst the plurality of zones, wherein the at least one first electrode and the at least one second electrode comprises a plurality of first electrodes and a plurality of second electrodes, respectively.

In this regard, the term *"zone"* refers to a specific section of the optical element, which is delineated for the purpose of individually measuring and controlling properties of the LC material within that section. Herein, each zone has a corresponding test circuit and is defined by a fractional portion of the total length of the trace and an area of the LC crystal material. Each zone has a portion of the RCR network, specifically the fraction of the total trace length and an area of the LC material. Herein, division of the optical element into the plurality of zones enables the at least one processor to perform spatially resolved diagnostics, wherein at least one of: the ageing of the mesogens, the alignment material ageing, the production variance are detected on a localized basis rather than only globally. Such localization allows early identification of at least one of: hot spots, non-uniform degradation, electrode wear.

Despite being divided into multiple zones, it is essential that all zones behave uniformly over time. This uniform behavior ensures that the ageing characteristics and performance testing results that the optical element remain consistent across all zones. When deviations are detected in a given zone, the at least one processor identifies this as indicative of at least one of: localized ageing of the mesogens, localized alignment material ageing, localized production variance. The at least one processor is then configured to apply zone-specific compensation to the drive signal, thereby restoring uniform optical performance across the optical element.

Moreover, the test signal for ageing and performance evaluation can be applied to a single zone, and the results from the single zone's testing should be applicable to all other zones. Optionally, comparative analysis of the plurality of zones is performed to validate whether degradation is systemic or localised, improving diagnostic reliability. This approach simplifies testing procedures while ensuring that the performance and ageing characteristics of the optical element are accurately assessed across its entire surface.

Moreover, the test circuit is embedded within the electrode traces corresponding to the same zone, such that both the at least one first electrode and the at least one second electrode each contribute fractions to the test circuit in a given zone, thereby forming a localized measurement unit. A technical effect of dividing the optical element into the plurality of zones and embedding fractions of the test circuit into corresponding electrode traces provides simplified testing and enhanced diagnostic granularity. By localizing the test circuit within the electrode traces and the LC material corresponding to the given zone, the at least one processor can detect local variations in capacitance that correspond to at least one of: the ageing of the mesogens, the alignment material ageing, the production variance. Another technical effect is that deviations between the plurality of zones are used as diagnostic indicators, enabling the at least one processor to identify non-uniform ageing or localized defects while ensuring that global uniformity across the plurality of zones is preserved. This zonal fractioning allows predictive adjustment of the driving parameters in affected zones, thereby maintaining consistent optical performance across the optical element. Furthermore, the zone-based approach enables efficient testing, wherein the test signal can be applied to a single zone while ensuring extrapolation to the entire optical element under conditions of uniformity, thus simplifying testing procedures while retaining the capability to identify localized anomalies.

Optionally, when applying the first input signal to the test circuit to measure the first output signal, the at least one processor is configured to apply the first input signal to the test circuit in the given zone, and when applying the second input signal to the test circuit to measure the second output signal, the at least one processor is configured to apply the second input signal to the test circuit in the given zone.

In this regard, the at least one processor initiates by applying the first input signal to the test circuit embedded within the given zone of the optical element. Herein, the first input signal is a reference input signal, and the first output signal is a reference output signal. This first output signal is determined upon application of the first input signal, wherein the first output signal represents a measured capacitance change, impedance variation, or another electrical characteristic relevant to the performance of the optical element. Subsequently, the at least one processor applies the second input signal to the same test circuit located in the given zone. Herein, the second input signal is a test input signal and the second output signal is a test output signal. The first output signal and the second output signal are then compared with each other to determine any changes within the LC material that is indicative of changes in the state of the mesogens.

Advantageously, by restricting both the reference input signal and the test input signal to the same zone, the at least one processor is able to isolate localized variations in capacitance that would otherwise be averaged out in global measurements. This isolation enables generation of zone-wise diagnostic data, wherein deviations between zones are mapped as indicators of mesogen ageing, alignment material ageing, or production variance.

It will also be appreciated that testing within specific zones enables for detailed analysis of how each zone performs independently, aiding in pinpointing areas of improvement and/or monitoring ageing effects. Furthermore, zonal application of the first input signal and the second input signal allows the at least one processor to construct a comparative zone-wise capacitance variation map, which supports predictive compensation of the at least one drive parameter in affected zones while maintaining uniform optical performance across the entire optical element.

A technical effect of the aforementioned feature is that it enables precise and localized characterization of electrical properties within specific zone of the optical element. Another technical effect is that such localized testing creates a synergistic diagnostic framework, comprising global uniformity and localized deviations. Herein, the global uniformity can be verified under normal conditions, while localized deviations reveal emerging faults, enabling proactive correction and extending operational longevity of the optical unit.

### EXPERIMENTAL PART

In an exemplary experimental part, an effect of temperature on the capacitance of the LC material within the optical element was assessed. The optical element the LC material that comprises the mesogens, was evaluated under varying temperature conditions to identify the relationship between temperature changes and responsiveness of the mesogens.

For establishing reference values, the optical unit was used in an environment at room temperature, i.e., at 21 degrees Celsius. The first input signal was applied to the test circuit of the optical unit to measure the first output signal at the first time instant, wherein the first output signal was in a form of a sinusoidal waveform. The reference peak voltage of the first output signal corresponds to a peak value of the sinusoidal waveform, wherein the peak value was at 5 volts. Thereafter, to test the test circuit, the optical unit was used in an environment wherein said optical element of the optical unit was heated using hot air. Herein, the hot air was not too hot, which made the temperature of the optical unit raise to 24 degrees Celsius, thereby making the optical element warm to touch when compared to the optical unit that was used in the environment at the room temperature. The second input signal was applied to the test circuit of the optical unit to measure the second output signal at the second time instant, wherein the second output signal is in a form of the sinusoidal waveform of an amplitude greater an amplitude of the sinusoidal waveform of the first output signal. The test peak voltage of the second output signal corresponds to a peak value of the sinusoidal waveform, wherein the peak value was at 8 volts. Subsequently, the test peak voltage, i.e., 5 volts is compared with the reference peak voltage, i.e., 8 volts, to determine the variation in the capacitance of the mesogens between the first time instant and the second time instant.

The present disclosure also relates to the second aspect as described above. Various embodiments and variants disclosed above, with respect to the aforementioned first aspect, apply *mutatis mutandis* to the second aspect.

Optionally, the method further comprising determining at least one of: a temperature of the mesogens at the second time instant, an ageing of the mesogens, an alignment material ageing, a production variance of the mesogens, based on the state of the mesogens.

### DETAILED DESCRIPTION OF THE DRAWINGS

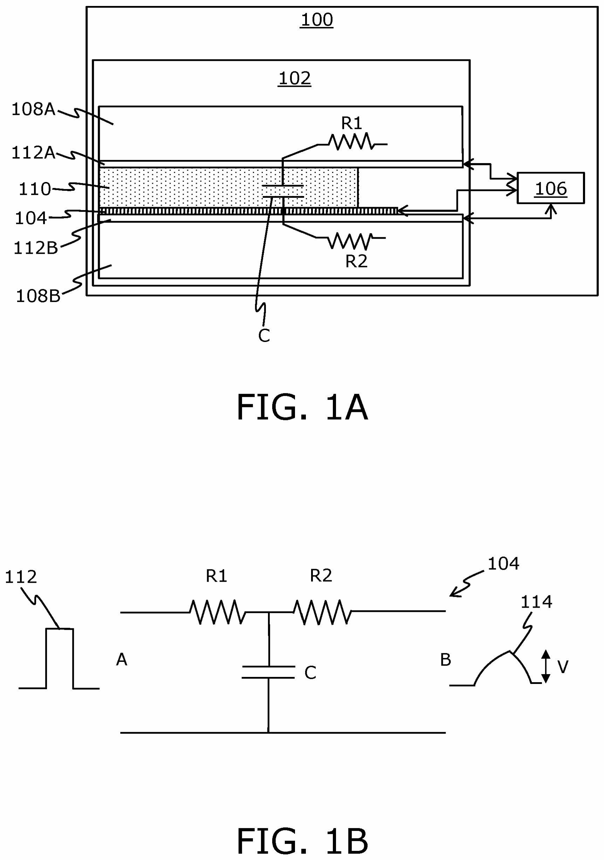

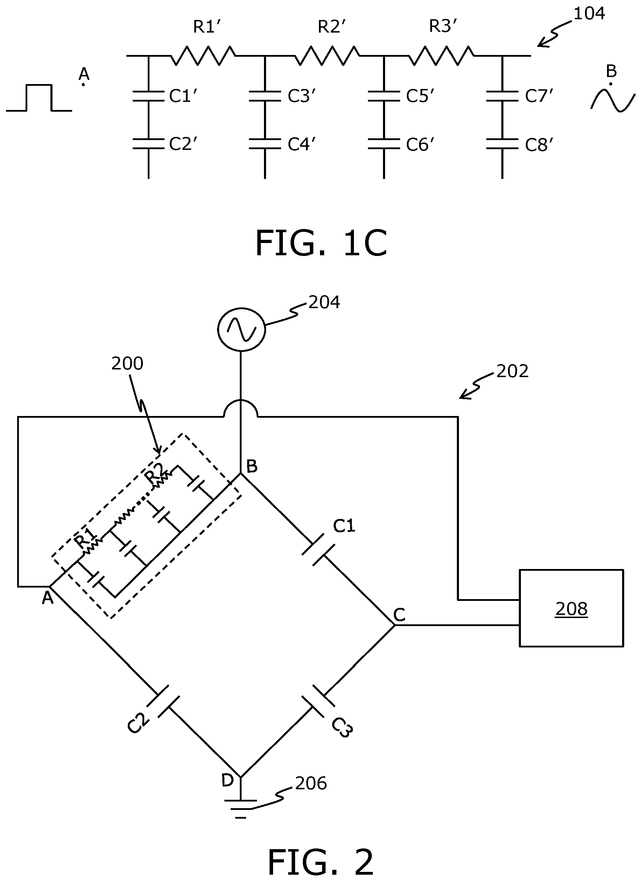

Referring to FIG. 1A, illustrated is a schematic illustration of an optical unit **100,** referring to FIG. 1B, illustrated is an equivalent circuit of a test circuit **104,** and referring to FIG. 1C, illustrated is an actual circuit of the test circuit **104,** in accordance with an embodiment of the present disclosure.

With reference to FIG. 1A, the optical unit **100** comprises an optical element **102,** a test circuit **104,** and at least one processor (depicted as a processor **106).** Herein, the optical element **102** comprises: a first substrate **108A;** a second substrate **108B;** a liquid crystal material **110** comprising mesogens; at least one first electrode (depicted as a first electrode **112A)** deposited on a surface of the first substrate **108A** and disposed between the first substrate **108A** and the liquid crystal material **110;** at least one second electrode (depicted as a second electrode **112B)** deposited on a surface of the second substrate **108B** and disposed between the second substrate **108B** and the liquid crystal material **110.** Herein, the test circuit **104** comprises: a first resistor **R1** formed by a trace of the first electrode **112A;** a second resistor **R2** formed by a trace of the second electrode **112B;** and a test capacitor **C** formed by the liquid crystal material **110,** wherein the first resistor **R1,** the second resistor **R2,** and the test capacitor **C** are connected in series, the first resistor **R1** being connected to a first terminal of the test capacitor **C,** and the second resistor **R2** being connected to a second terminal of the test capacitor **C.** The processor **106** is configured to perform various operations as described earlier.

With reference to FIG. 1B, the test circuit **104** also comprises an input port **A** and an output port **B.** Herein, an input signal (depicted as a step voltage waveform **114)** is applied at the port **A** and a corresponding output signal (depicted as an exponential voltage waveform **116)** is obtained at the port **B.**

With reference to FIG. 1C, the actual circuit of the test circuit **104** comprises three resistors **R1', R2',** and **R3'** that are connected in series, with each resistor having a pair of capacitors connected in parallel between an electrical ground and a power source. Herein, the resistor **R1'** is connected to the two capacitors **C1'**and **C2',** which are in parallel to each other and connected to the electrical ground. The resistors **R2',** and **R3'** are connected to the two capacitors **C3'** and **C4', C5'** and **C6',** and **C7'** and **C8'** in a similar manner. From FIG. 1B, the equivalent circuit of the test circuit **104** is derived by simplifying the actual circuit of the test circuit **104.**

FIGs. 1A-1C are merely examples, which should not unduly limit the scope of the claims herein. A person skilled in the art will recognize many variations, alternatives, and modifications of embodiments of the present disclosure.

Referring to FIG. 2, illustrated is an exemplary implementation of a test circuit **200** when incorporated into a Wheatstone bridge configuration **202,** in accordance with an embodiment of the present disclosure. With reference to FIG. 2, the Wheatstone bridge configuration **202** comprises: a first arm **AB,** a second arm **BC,** a third arm **AD,** and a fourth arm **CD.** Herein, the first arm **AB** comprises the test circuit **200** that is arranged between a first node **A** and a second node **B,** the first resistor **R1** being connected to the first node **A** and the second resistor being **R2** connected to the second node **B,** wherein the second node **B** is connected to a power source **204.** The second arm **BC** comprises a first capacitor **C1** arranged between the second node **B** and a third node **C.** The third arm **AD** comprises a second capacitor **C2** arranged between the first node **A** and a fourth node **D,** wherein the fourth node **D** is connected to an electrical ground **206.** The fourth arm **CD** comprises a third capacitor **C3** arranged between the third node **C** and the fourth node **D,** wherein a data processing unit **208** is arranged between the first node **A** and the third node **C.** Optionally, the data processing unit **208** comprises an analog-to-digital converter (ADC).

FIG. 2 is merely an example, which should not unduly limit the scope of the claims herein. A person skilled in the art will recognize many variations, alternatives, and modifications of embodiments of the present disclosure.

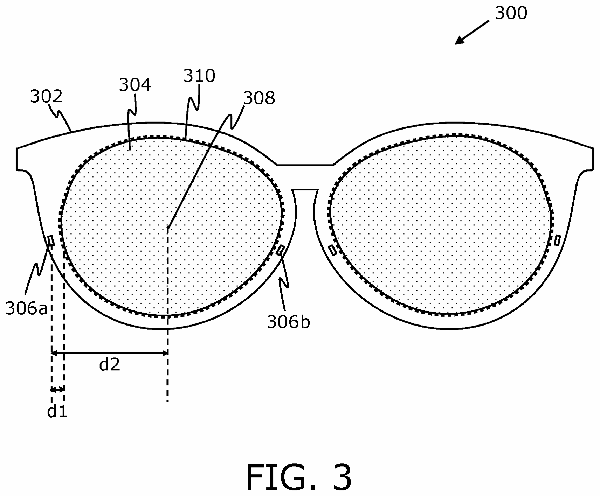

Referring to FIG. 3, there is shown a schematic illustration of an optical unit **300,** in accordance with an embodiment of the present disclosure. With reference to FIG. 3, the optical unit **300** is implemented as a spectacle. Optionally, the optical unit **300** further comprises a frame **302** that is employed to hold an optical element **304,** wherein the frame **302** has at least one temperature sensor (depicted as temperature sensors **306a** and **306b)** embedded therein, the temperature sensors **306a-b** being arranged at at least one of: a first predefined distance **d1** from an edge at which the optical element **304** interfaces with the frame **300;** a second predefined distance **d2** from a centre **308** of the optical element **304.** Optionally, the optical unit **300** further comprises a sealant **310** that is applied at the interface between the optical element **304** and the frame **302** to ensure a secure fit of the optical element **304** within the frame **302.**

FIG. 3 is merely an example, which should not unduly limit the scope of the claims herein. A person skilled in the art will recognize many variations, alternatives, and modifications of embodiments of the present disclosure.

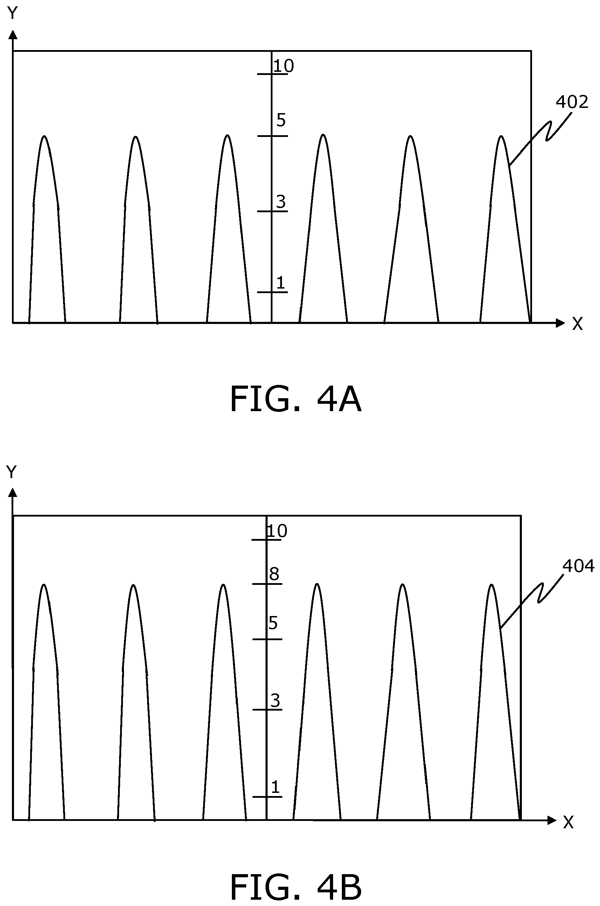

Referring to FIGs. 4A and 4B, illustrated is a graphical representation of an exemplary experimentation part conducted using an optical unit **100** of FIG. 1, to determine an effect of temperature on a capacitance of mesogens within an optical element **102** of the optical unit **100,** in accordance with an embodiment of the present disclosure. Herein, a vertical axis (depicted as Y-axis) represents variation in the capacitance of mesogens as a function of applied voltage, and a horizontal axis (depicted as X-axis) represents a temperature of the optical unit.

With reference to FIG. 4A, for establishing reference values, the optical unit **100** was used in an environment at room temperature, i.e., 21 degrees. The first input signal was applied to the test circuit of the optical unit **100** to measure the first output signal at the first time instant, wherein the first output signal was in a form of a sinusoidal waveform **402.** The reference peak voltage of the first output signal corresponds to a peak value of the sinusoidal waveform **402,** wherein the peak value was at 5 volts.

With reference to FIG. 4B, to test the test circuit, the optical unit **100** was used in an environment wherein said optical element **102** of the optical unit **100** was heated using hot air. Herein, the hot air was not too hot, which made the temperature of the optical unit **100** raise to 24 degrees Celsius, thereby making the optical element **102** warm to touch when compared to the optical unit **100** that was used in the environment at the room temperature. The second input signal was applied to the test circuit of the optical unit **100** to measure the second output signal at the second time instant, wherein the second output signal is in a form of another sinusoidal waveform **404** of an amplitude greater an amplitude of the sinusoidal waveform **402** of the first output signal. The test peak voltage of the second output signal corresponds to a peak value of the another sinusoidal waveform **404,** wherein the peak value was at 8 volts. Subsequently, the test peak voltage, i.e., 5 volts is compared with the reference peak voltage, i.e., 8 volts, to determine the variation in the capacitance of the mesogens between the first time instant and the second time instant.

FIGs. 4A and 4B are merely examples, which should not unduly limit the scope of the claims herein. A person skilled in the art will recognize many variations, alternatives, and modifications of embodiments of the present disclosure.

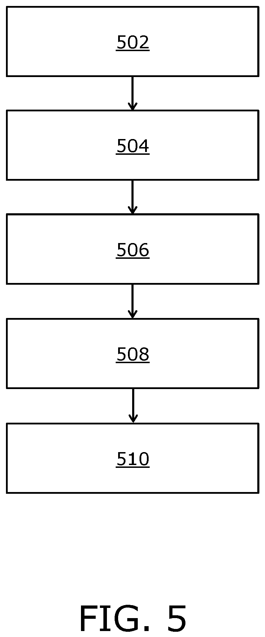

Referring to FIG. 5, illustrated are steps of a method implemented by an optical unit, in accordance with an embodiment of the present disclosure. At step **502,** a first input signal is applied to a test circuit to measure a first output signal, and a reference peak voltage of the first output signal is determined at a first time instant. At step **504,** a second input signal is applied to the test circuit to measure a second output signal, and a test peak voltage of the second output signal is determined at a second time instant. At step **506,** a variation in a capacitance of the mesogens is determined between the first time instant and the second time instant, by comparing the test peak voltage with the reference peak voltage. At step **508,** a state of the mesogens at the second time instant is determined, based on the variation in the capacitance of the mesogens. At step **510,** at least one driving parameter of a drive signal is adjusted to drive at least one of: the at least one first electrode, the at least one second electrode, to change at least one optical parameter of the optical element, based on the state of the mesogens.

The aforementioned steps are only illustrative and other alternatives can also be provided where one or more steps are added, one or more steps are removed, or one or more steps are provided in a different sequence without departing from the scope of the claims herein.

## Claims

1. An optical unit (100, 300) comprising:
an optical element (102, 304) comprising:
a first substrate (108A) and a second substrate (108B);
a liquid crystal material (110) comprising mesogens;
at least one first electrode (112A) deposited on a surface of the first substrate and disposed between the first substrate and the liquid crystal material;
at least one second electrode (112B) deposited on a surface of the second substrate and disposed between the second substrate and the liquid crystal material;
a test circuit (104, 200) comprising:
a first resistor (R1) formed by a trace of the at least one first electrode;
a second resistor (R2) formed by a trace of the at least one second electrode; and
a test capacitor (C) formed by the liquid crystal material,
wherein the first resistor, the second resistor, and the test capacitor are connected in series, the first resistor being connected to a first terminal of the test capacitor, and the second resistor being connected to a second terminal of the test capacitor; and
at least one processor (106) configured to:
apply a first input signal to the test circuit to measure a first output signal, and determine a reference peak voltage of the first output signal at a first time instant;
apply a second input signal to the test circuit to measure a second output signal, and determine a test peak voltage of the second output signal at a second time instant;
determine a variation in a capacitance of the mesogens between the first time instant and the second time instant, by comparing the test peak voltage with the reference peak voltage;
determine a state of the mesogens at the second time instant, based on the variation in the capacitance of the mesogens; and
adjust at least one driving parameter of a drive signal to drive at least one of: the at least one first electrode, the at least one second electrode, to change at least one optical parameter of the optical element, based on the state of the mesogens.

2. The optical unit (100, 300) of any of the preceding claims, wherein the state of the mesogens comprises at least one of: an orientation, a polarity, a rotation per unit voltage, of the mesogens.

3. The optical unit (100, 300) of any of claim 1 or 2, wherein the at least one processor (106) is further configured to determine at least one of: a temperature of the mesogens at the second time instant, an ageing of the mesogens, an alignment material ageing, a production variance of the mesogens, based on the state of the mesogens.

4. The optical unit (100, 300) of claim 3, further comprising at least one temperature sensor (306a, 306b), wherein when determining the temperature of the mesogens at the second time instant, the at least one processor (106) is further configured to:
receive a sensor data from the at least one temperature sensor, wherein the sensor data comprises values related to ambient temperature of the optical unit; and
process the sensor data to estimate the temperature of the mesogens at the second time instant.

5. The optical unit (100, 300) of claim 4, further comprising a frame (302) employed to hold the optical element (102, 304), wherein the frame has the at least one temperature sensor (306a, 306b) embedded therein, the at least one temperature sensor being arranged at at least one of:
a first predefined distance (d1) from an edge at which the optical element interfaces with the frame, wherein the first predefined distance lies in a range of 1 millimetre to 3 millimetres;
a second predefined distance (d2) from a centre (308) of the optical element, wherein the second predefined distance lies in a range of 20 millimetres to 30 millimetres.

6. The optical unit (100, 300) of claim 3, wherein when determining at least one of: the ageing of the mesogens, the alignment material ageing, the production variance of the mesogens, the at least one processor (106) is further configured to:
apply plurality of reference input signals to the test circuit (104, 200) to measure plurality of reference output signals at a third time instant, each of the plurality of reference output signals corresponds to each of the plurality of reference input signals;
apply plurality of test input signals to the test circuit to measure plurality of test output signals at a fourth time instant, each of the plurality of test input signals corresponds to each of the plurality of test output signals; and
determine a given test input signal at which at least one property of the mesogens changes, by comparing each of the plurality of test output signals with corresponding reference output signal from amongst the plurality of reference output signals, wherein the given test input signal is determined to be a threshold voltage.

7. The optical unit (100, 300) of claim 3, wherein when determining at least one of: the ageing of the mesogens, the alignment material ageing, the production variance of the mesogens, the at least one processor (106) is further configured to:
apply plurality of reference input frequency signals to the test circuit (104, 200) to measure plurality of reference output frequency signals, each of the plurality of reference input frequency signals corresponds to each of the plurality of reference output frequency signals, to determine plurality of reference time instants taken to achieve the plurality of reference frequency responses;
apply plurality of test frequencies to the test circuit to measure plurality of test frequency responses, each of the plurality of test frequencies being corresponding to each of the plurality of test frequency responses, to determine plurality of test time instants taken to achieve the plurality of test frequency responses; and
determine a given test time instant at which a response speed of the liquid crystal material (110) changes in response to a given frequency, by comparing each of the plurality of test frequency response to corresponding reference frequency response from amongst the plurality of reference frequency responses.

8. The optical unit (100, 300) of claim 3, wherein the test circuit (104, 200) is incorporated into a Wheatstone bridge configuration (202), said Wheatstone bridge configuration comprising:
a first arm (AB) comprising the test circuit that is arranged between a first node (A) and a second node (B), the first resistor (R1) being connected to the first node and the second resistor (R2) being connected to the second node, wherein the second node is connected to a power source (204);
a second arm (BC) comprising a first capacitor (C1) arranged between the second node and a third node (C);
a third arm (AD) comprising a second capacitor (C2) arranged between the first node and a fourth node (D), wherein the fourth node is connected to an electrical ground (206); and
a fourth arm (CD) comprising a third capacitor (C3) arranged between the third node and the fourth node,
wherein a data processing unit (ADC) (208) is arranged between the first node and the third node,
wherein when determining at least one of: the ageing of the mesogens, the alignment material ageing, the production variance of the mesogens, the at least one processor (106) is further configured to:
apply a third input signal at the second node to determine a first operational point, wherein a third output signal corresponding to the third input signal is measured by the data processing unit;
apply a fourth input signal at the second node to determine a second operational point wherein a fourth output signal corresponding to the fourth input signal is measured by the data processing unit;
compare the third output signal and the fourth output signal to determine a variation of capacitance between the first operational point and the second operational point; and
when the variation of capacitance between the first operational point and the second operational point exceeds a predefined threshold, identify that there is at least one of: the ageing of the mesogens, the alignment material ageing, the production variance of the mesogens.

9. The optical unit (100, 300) of any of the preceding claims, wherein when the optical element (102, 304) is divided into a plurality of zones, the test circuit (104, 200) in a given zone comprises a fraction of the first resistor, a fraction of the second resistor, and a fraction of the test capacitor, wherein the fraction of the first resistor and the fraction of the second resistor correspond to a fraction of a total length of the trace of the at least one first electrode (112A) and the at least one second electrode (112B), respectively, and the fraction of the test capacitor corresponds to an area of the liquid crystal material,
wherein the test circuit is embedded in any one of: the at least one first electrode, the at least one second electrode, corresponding to at least one zone from amongst the plurality of zones, wherein the at least one first electrode and the at least one second electrode comprises a plurality of first electrodes and a plurality of second electrodes, respectively.

10. The optical unit (100, 300) of claim 9, wherein when applying the first input signal to the test circuit (104, 200) to measure the first output signal, the at least one processor (106) is configured to apply the first input signal to the test circuit in the given zone, and
when applying the second input signal to the test circuit to measure the second output signal, the at least one processor is configured to apply the second input signal to the test circuit in the given zone.

11. The optical unit (100, 300) of any of the preceding claims, wherein the at least one driving parameter comprises at least one of: an amplitude, a frequency, of the drive signal.

12. The optical unit (100, 300) of any of the preceding claims, wherein the at least one optical parameter comprises at least one of: at least one optical power to be produced, a position of at least one region of the optical element (102, 304) in which the at least one optical power is to be produced, a profile of the optical element, a transparency of at least a portion of the optical element, an operational mode of the optical element.

13. The optical unit (100, 300) of any of the preceding claims, wherein the input signal is any one of: an impulse voltage signal, a step voltage signal (114), a ramp voltage signal.

14. A method implemented by an optical unit (100, 300) as claimed in claim 1, the method comprising:
applying a first input signal to a test circuit (104, 200) to measure a first output signal, and determine a reference peak voltage of the first output signal at a first time instant;
applying a second input signal to the test circuit to measure a second output signal, and determine a test peak voltage of the second output signal at a second time instant;
determining a variation in a capacitance of the mesogens between the first time instant and the second time instant, by comparing the test peak voltage with the reference peak voltage;
determining a state of the mesogens at the second time instant, based on the variation in the capacitance of the mesogens; and
adjusting at least one driving parameter of a drive signal to drive at least one of: the at least one first electrode, the at least one second electrode, to change at least one optical parameter of the optical element (102, 304), based on the state of the mesogens.

15. The method of claim 14, further comprising determining at least one of: a temperature of the mesogens at the second time instant, an ageing of the mesogens, an alignment material ageing, a production variance of the mesogens, based on the state of the mesogens.

## Patentansprüche

1. Optische Einheit (100, 300), umfassend:
ein optisches Element (102, 304), umfassend:
ein erstes Substrat (108A) und ein zweites Substrat (108B);
ein Flüssigkristallmaterial (110) umfassend Mesogene;
mindestens eine erste Elektrode (112A), die auf einer Oberfläche des ersten Substrats abgeschieden ist und zwischen dem ersten Substrat und dem Flüssigkristallmaterial angeordnet ist;
mindestens eine zweite Elektrode (112B), die auf einer Oberfläche des zweiten Substrats abgeschieden ist und zwischen dem zweiten Substrat und dem Flüssigkristallmaterial angeordnet ist;
eine Testschaltung (104, 200), umfassend:
einen ersten Widerstand (R.1), der durch eine Leiterbahn der mindestens einen ersten Elektrode gebildet ist;
einen zweiten Widerstand (R.2), der durch eine Leiterbahn der mindestens einen zweiten Elektrode gebildet ist; und
einen Testkondensator (C), der durch das Flüssigkristallmaterial gebildet ist,
wobei der erste Widerstand, der zweite Widerstand und der Testkondensator in Reihe geschaltet sind, wobei der erste Widerstand mit einem ersten Anschluss des Testkondensators verbunden ist und der zweite Widerstand mit einem zweiten Anschluss des Testkondensators verbunden ist; und
mindestens einen Prozessor (106), ausgelegt zum:
Anlegen eines ersten Eingangssignals an die Testschaltung zum Messen eines ersten Ausgangssignals, und Bestimmen einer Referenzspitzenspannung des ersten Ausgangssignals zu einem ersten Zeitpunkt;
Anlegen eines zweiten Eingangssignals an die Testschaltung zum Messen eines zweiten Ausgangssignals, und Bestimmen einer Testspitzenspannung des zweiten Ausgangssignals zu einem zweiten Zeitpunkt;
Bestimmen einer Änderung einer Kapazität der Mesogene zwischen dem ersten Zeitpunkt und dem zweiten Zeitpunkt durch Vergleichen der Testspitzenspannung mit der Referenzspitzenspannung;
Bestimmen eines Zustands der Mesogene zu dem zweiten Zeitpunkt basierend auf der Änderung der Kapazität der Mesogene; und
Anpassen mindestens eines Ansteuerparameters eines Ansteuersignals zum Ansteuern mindestens einer von: der mindestens einen ersten Elektrode, der mindestens einen zweiten Elektrode, um mindestens einen optischen Parameter des optischen Elements basierend auf dem Zustand der Mesogene zu ändern.

2. Optische Einheit (100, 300) nach einem der vorhergehenden Ansprüche, wobei der Zustand der Mesogene mindestens eines umfasst von: einer Orientierung, einer Polarität, einer Drehung pro Spannungseinheit der Mesogene.

3. Optische Einheit (100, 300) nach einem der Ansprüche 1 oder 2, wobei der mindestens eine Prozessor (106) ferner ausgelegt ist zum Bestimmen mindestens eines von: einer Temperatur der Mesogene zu dem zweiten Zeitpunkt, einer Alterung der Mesogene, einer Orientierungsmaterialalterung, einer Produktionsvarianz der Mesogene, basierend auf dem Zustand der Mesogene.

4. Optische Einheit (100, 300) nach Anspruch 3, ferner umfassend mindestens einen Temperatursensor (306a, 306b), wobei bei dem Bestimmen der Temperatur der Mesogene zu dem zweiten Zeitpunkt der mindestens eine Prozessor (106) ferner ausgelegt ist zum:
Empfangen von Sensordaten von dem mindestens einen Temperatursensor, wobei die Sensordaten Werte bezüglich einer Umgebungstemperatur der optischen Einheit umfassen; und
Verarbeiten der Sensordaten zum Schätzen der Temperatur der Mesogene zu dem zweiten Zeitpunkt.

5. Optische Einheit (100, 300) nach Anspruch 4, ferner umfassend einen Rahmen (302), der zum Halten des optischen Elements (102, 304) eingesetzt wird, wobei der Rahmen den mindestens einen darin eingebetteten Temperatursensor (306a, 306b) aufweist, wobei der mindestens eine Temperatursensor in mindestens einem angeordnet ist von:
einem ersten vordefinierten Abstand (dl) von einer Kante, an der das optische Element mit dem Rahmen eine Grenzfläche bildet, wobei der erste vordefinierte Abstand in einem Bereich von 1 Millimeter bis 3 Millimeter liegt;
einem zweiten vordefinierten Abstand (d2) von einem Zentrum (308) des optischen Elements, wobei der zweite vordefinierte Abstand in einem Bereich von 20 mm bis 30 mm liegt.

6. Optische Einheit (100, 300) nach Anspruch 3, wobei bei dem Bestimmen mindestens eines von: der Alterung der Mesogene, der Orientierungsmaterialalterung, der Produktionsvarianz der Mesogene, der mindestens eine Prozessor (106) ferner ausgelegt ist zum:
Anlegen einer Vielzahl von Referenzeingangssignalen an die Testschaltung (104, 200) zum Messen einer Vielzahl von Referenzausgangssignalen zu einem dritten Zeitpunkt, wobei jedes der Vielzahl von Referenzausgangssignalen jedem der Vielzahl von Referenzeingangssignalen entspricht;
Anlegen einer Vielzahl von Testeingangssignalen an die Testschaltung zum Messen einer Vielzahl von Testausgangssignalen zu einem vierten Zeitpunkt, wobei jedes der Vielzahl von Testeingangssignalen jedem der Vielzahl von Testausgangssignalen entspricht; und
Bestimmen eines gegebenen Testeingangssignals, bei dem sich mindestens eine Eigenschaft der Mesogene ändert, durch Vergleichen jedes der Vielzahl von Testausgangssignalen mit einem entsprechenden Referenzausgangssignal aus der Vielzahl von Referenzausgangssignalen, wobei das gegebene Testeingangssignal als eine Schwellenspannung bestimmt wird.

7. Optische Einheit (100, 300) nach Anspruch 3, wobei bei dem Bestimmen mindestens eines von: der Alterung der Mesogene, der Orientierungsmaterialalterung, der Produktionsvarianz der Mesogene, der mindestens eine Prozessor (106) ferner ausgelegt ist zum:
Anlegen einer Vielzahl von Referenzeingangsfrequenzsignalen an die Testschaltung (104, 200) zum Messen einer Vielzahl von Referenzausgangsfrequenzsignalen, wobei jedes der Vielzahl von Referenzeingangsfrequenzsignalen jedem der Vielzahl von Referenzausgangsfrequenzsignalen entspricht, um eine Vielzahl von Referenzzeitpunkten, die zum Erreichen der Vielzahl von Referenzfrequenzgängen verwendet werden, zu bestimmen;
Anlegen einer Vielzahl von Testfrequenzen an die Testschaltung zum Messen einer Vielzahl von Testfrequenzgängen, wobei jede der Vielzahl von Testfrequenzen jeder der Vielzahl von Testfrequenzgängen entspricht, um eine Vielzahl von Testzeitpunkten, die zum Erreichen der Vielzahl von Testfrequenzgängen verwendet werden, zu bestimmen; und
Bestimmen eines gegebenen Testzeitpunkts, zu dem sich eine Reaktionsgeschwindigkeit des Flüssigkristallmaterials (110) in Reaktion auf eine gegebene Frequenz ändert, durch Vergleichen jedes der Vielzahl von Testfrequenzgängen mit einem entsprechenden Referenzfrequenzgang aus der Vielzahl von Referenzfrequenzgängen.

8. Optische Einheit (100, 300) nach Anspruch 3, wobei die Testschaltung (104, 200) in eine Wheatstone-Brückenkonfiguration (202) integriert ist, wobei die Wheatstone-Brückenkonfiguration umfasst:
einen ersten Arm (AB), umfassend die Testschaltung, die zwischen einem ersten Knoten (A) und einem zweiten Knoten (B) angeordnet ist, wobei der erste Widerstand (R.1) mit dem ersten Knoten verbunden ist und der zweite Widerstand (R.2) mit dem zweiten Knoten verbunden ist, wobei der zweite Knoten mit einer Stromquelle (204) verbunden ist;
einen zweiten Arm (BC), umfassend einen ersten Kondensator (Cl), der zwischen dem zweiten Knoten und einem dritten Knoten (C) angeordnet ist;
einen dritten Arm (AD), umfassend einen zweiten Kondensator (C2), der zwischen dem ersten Knoten und einem vierten Knoten (D) angeordnet ist, wobei der vierte Knoten mit einer elektrischen Masse (206) verbunden ist; und
einen vierten Arm (CD), umfassend einen dritten Kondensator (C3), der zwischen dem dritten Knoten und dem vierten Knoten angeordnet ist, wobei eine Datenverarbeitungseinheit (ADC) (208) zwischen dem ersten Knoten und dem dritten Knoten angeordnet ist, wobei bei dem Bestimmen mindestens eines von: der Alterung der Mesogene, der Orientierungsmaterialalterung, der Produktionsvarianz der Mesogene, der mindestens eine Prozessor (106) ferner ausgelegt ist zum:
Anlegen eines dritten Eingangssignals an den zweiten Knoten zum Bestimmen eines ersten Arbeitspunkts, wobei ein dem dritten Eingangssignal entsprechendes drittes Ausgangssignal durch die Datenverarbeitungseinheit gemessen wird;
Anlegen eines vierten Eingangssignals an den zweiten Knoten zum Bestimmen eines zweiten Arbeitspunkts, wobei ein dem vierten Eingangssignal entsprechendes viertes Ausgangssignal durch die Datenverarbeitungseinheit gemessen wird;
Vergleichen des dritten Ausgangssignals und des vierten Ausgangssignals zum Bestimmen einer Änderung der Kapazität zwischen dem ersten Arbeitspunkt und dem zweiten Arbeitspunkt; und
wenn die Änderung der Kapazität zwischen dem ersten Arbeitspunkt und dem zweiten Arbeitspunkt einen vordefinierten Schwellenwert überschreitet, Identifizieren mindestens eines von: der Alterung der Mesogene, der Orientierungsmaterialalterung, der Produktionsvarianz der Mesogene.

9. Optische Einheit (100, 300) nach einem der vorhergehenden Ansprüche, wobei, wenn das optische Element (102, 304) in eine Vielzahl von Zonen unterteilt ist, die Testschaltung (104, 200) in einer gegebenen Zone einen Anteil des ersten Widerstands, einen Anteil des zweiten Widerstands und einen Anteil des Testkondensators umfasst, wobei der Anteil des ersten Widerstands und der Anteil des zweiten Widerstands jeweils einem Anteil einer Gesamtlänge der Leiterbahn der mindestens einen ersten Elektrode (112A) und der mindestens einen zweiten Elektrode (112B) entsprechen und der Anteil des Testkondensators einer Fläche des Flüssigkristallmaterials entspricht,
wobei die Testschaltung in mindestens eine eingebettet ist von: der mindestens einen erste Elektrode, der mindestens einen zweiten Elektrode, die mindestens einer Zone aus der Vielzahl von Zonen entspricht, wobei die mindestens eine erste Elektrode und die mindestens eine zweite Elektrode jeweils eine Vielzahl von ersten Elektroden und eine Vielzahl von zweiten Elektroden umfasst.

10. Optische Einheit (100, 300) nach Anspruch 9, wobei, wenn das erste Eingangssignal an die Testschaltung (104, 200) zum Messen des ersten Ausgangssignals angelegt wird, der mindestens eine Prozessor (106) ausgelegt ist zum Anlegen des ersten Eingangssignals an die Testschaltung in der gegebenen Zone, und
wenn das zweite Eingangssignal an die Testschaltung zum Messen des zweiten Ausgangssignals angelegt wird, der mindestens eine Prozessor ausgelegt ist zum Anlegen des zweiten Eingangssignals an die Testschaltung in der gegebenen Zone.

11. Optische Einheit (100, 300) nach einem der vorhergehenden Ansprüche, wobei der mindestens eine Ansteuerparameter mindestens eines umfasst von: einer Amplitude, einer Frequenz des Ansteuersignals.

12. Optische Einheit (100, 300) nach einem der vorhergehenden Ansprüche, wobei der mindestens eine optische Parameter mindestens eine umfasst von: mindestens einer zu erzeugenden optischen Leistung, einer Position mindestens eines Bereichs des optischen Elements (102, 304), in dem die mindestens eine optische Leistung zu erzeugen ist, einem Profil des optischen Elements, einer Transparenz mindestens eines Abschnitts des optischen Elements, einem Betriebsmodus des optischen Elements.

13. Optische Einheit (100, 300) nach einem der vorhergehenden Ansprüche, wobei das Eingangssignal ein beliebiges ist von: einem Impulsspannungssignal, einem Sprungspannungssignal (114), einem Rampenspannungssignal.

14. Verfahren, das von einer optischen Einheit (100, 300) nach Anspruch 1 implementiert wird, das Verfahren umfassend:
Anlegen eines ersten Eingangssignals an eine Testschaltung (104, 200) zum Messen eines ersten Ausgangssignals, und Bestimmen einer Referenzspitzenspannung des ersten Ausgangssignals zu einem ersten Zeitpunkt;
Anlegen eines zweiten Eingangssignals an die Testschaltung zum Messen eines zweiten Ausgangssignals, und Bestimmen einer Testspitzenspannung des zweiten Ausgangssignals zu einem zweiten Zeitpunkt;
Bestimmen einer Änderung einer Kapazität der Mesogene zwischen dem ersten Zeitpunkt und dem zweiten Zeitpunkt durch Vergleichen der Testspitzenspannung mit der Referenzspitzenspannung;
Bestimmen eines Zustands der Mesogene zu dem zweiten Zeitpunkt basierend auf der Änderung der Kapazität der Mesogene; und
Anpassen mindestens eines Ansteuerparameters eines Ansteuersignals zum Ansteuern mindestens einer von: der mindestens einen ersten Elektrode, der mindestens einen zweiten Elektrode, um mindestens einen optischen Parameter des optischen Elements (102, 304) basierend auf dem Zustand der Mesogene zu ändern.

15. Verfahren nach Anspruch 14, ferner umfassend das Bestimmen mindestens eines von: einer Temperatur der Mesogene zu dem zweiten Zeitpunkt, einer Alterung der Mesogene, einer Orientierungsmaterialalterung, einer Produktionsvarianz der Mesogene, basierend auf dem Zustand der Mesogene.

## Revendications

1. Unité optique (100, 300) comprenant :
un élément optique (102, 304) comprenant :
un premier substrat (108A) et un deuxième substrat (108B) ;
un matériau à cristaux liquides (110) comprenant des mésogènes ;
au moins une première électrode (112A) déposée sur une surface du premier substrat et disposée entre le premier substrat et le matériau à cristaux liquides ;
au moins une deuxième électrode (112B) déposée sur une surface du deuxième substrat et disposée entre le deuxième substrat et le matériau à cristaux liquides ;
un circuit de test (104, 200) comprenant :
une première résistance (R.1) formée par une trace de l'au moins une première électrode ;
une deuxième résistance (R.2) formée par une trace de l'au moins une deuxième électrode ; et
un condensateur de test (C) formé par le matériau à cristaux liquides,
dans laquelle la première résistance, la deuxième résistance et le condensateur de test sont connectés en série, la première résistance étant connectée à une première borne du condensateur de test, et la deuxième résistance étant connectée à une deuxième borne du condensateur de test ; et
au moins un processeur (106) configuré pour :
appliquer un premier signal d'entrée au circuit de test afin de mesurer un premier signal de sortie, et déterminer une tension de crête de référence du premier signal de sortie à un premier instant temporel ;
appliquer un deuxième signal d'entrée au circuit de test afin de mesurer un deuxième signal de sortie, et déterminer une tension de crête de test du deuxième signal de sortie à un deuxième instant temporel ;
déterminer une variation d'une capacité des mésogènes entre le premier instant temporel et le deuxième instant temporel, en comparant la tension de crête de test à la tension de crête de référence ;
déterminer un état des mésogènes au deuxième instant temporel, sur la base de la variation de la capacité des mésogènes ; et
régler au moins un paramètre de commande d'un signal de commande pour commander au moins l'un parmi : l'au moins une première électrode, l'au moins une deuxième électrode, afin de changer au moins un paramètre optique de l'élément optique, sur la base de l'état des mésogènes.

2. Unité optique (100, 300) selon l'une quelconque des revendications précédentes, dans laquelle l'état des mésogènes comprend au moins l'une parmi : une orientation, une polarité, une rotation par unité de tension, des mésogènes.

3. Unité optique (100, 300) selon l'une quelconque des revendications 1 ou 2, dans laquelle l'au moins un processeur (106) est en outre configuré pour déterminer au moins l'un parmi : une température des mésogènes au deuxième instant temporel, un vieillissement des mésogènes, un vieillissement de matériau d'alignement, une variabilité de production des mésogènes, sur la base de l'état des mésogènes.

4. Unité optique (100, 300) selon la revendication 3, comprenant en outre au moins un capteur de température (306a, 306b), dans laquelle, lors de la détermination de la température des mésogènes au deuxième instant temporel, l'au moins un processeur (106) est en outre configuré pour :
recevoir des données de capteur provenant de l'au moins un capteur de température, dans lequel les données de capteur comprennent des valeurs liées à la température ambiante de l'unité optique ; et
traiter les données de capteur afin d'estimer la température des mésogènes au deuxième instant temporel.

5. Unité optique (100, 300) selon la revendication 4, comprenant en outre un cadre (302) employé pour maintenir l'élément optique (102, 304), dans laquelle le cadre a l'au moins un capteur de température (306a, 306b) incorporé dans celui-ci, l'au moins un capteur de température étant agencé au niveau d'au moins l'une parmi :
une première distance prédéfinie (d1) à partir d'un bord au niveau duquel l'élément optique fait interface avec le cadre, dans laquelle la première distance prédéfinie se situe dans une plage de 1 millimètre à 3 millimètres ;
une deuxième distance prédéfinie (d2) à partir d'un centre (308) de l'élément optique, dans laquelle la deuxième distance prédéfinie se situe dans une plage de 20 millimètres à 30 millimètres.

6. Unité optique (100, 300) selon la revendication 3, dans laquelle, lors de la détermination d'au moins l'un parmi : le vieillissement des mésogènes, le vieillissement du matériau d'alignement, la variabilité de production des mésogènes, l'au moins un processeur (106) est en outre configuré pour :
appliquer une pluralité de signaux d'entrée de référence au circuit de test (104, 200) pour mesurer une pluralité de signaux de sortie de référence à un troisième instant temporel, chacun de la pluralité de signaux de sortie de référence correspond à chacun de la pluralité de signaux d'entrée de référence ;
appliquer une pluralité de signaux d'entrée de test au circuit de test pour mesurer une pluralité de signaux de sortie de test à un quatrième instant temporel, chacun de la pluralité de signaux d'entrée de test correspond à chacun de la pluralité de signaux de sortie de test ; et
déterminer un signal d'entrée de test donné auquel au moins une propriété des mésogènes change, en comparant chacun de la pluralité de signaux de sortie de test avec un signal de sortie de référence correspondant parmi la pluralité de signaux de sortie de référence, dans laquelle le signal d'entrée de test donné est déterminé comme étant une tension seuil.

7. Unité optique (100, 300) selon la revendication 3, dans laquelle, lors de la détermination d'au moins l'un parmi : le vieillissement des mésogènes, le vieillissement du matériau d'alignement, la variabilité de production des mésogènes, l'au moins un processeur (106) est en outre configuré pour :
appliquer une pluralité de signaux de fréquence d'entrée de référence au circuit de test (104, 200) pour mesurer une pluralité de signaux de fréquence de sortie de référence, chacun de la pluralité de signaux de fréquence d'entrée de référence correspond à chacun de la pluralité de signaux de fréquence de sortie de référence, pour déterminer une pluralité d'instants temporels de référence pris pour obtenir la pluralité de réponses de fréquence de référence ;
appliquer une pluralité de fréquences de test au circuit de test pour mesurer une pluralité de réponses de fréquence de test, chacune de la pluralité de fréquences de test correspondant à chacune de la pluralité de réponses de fréquence de test, pour déterminer une pluralité d'instants temporels de test pris pour obtenir la pluralité de réponses de fréquence de test ; et
déterminer un instant temporel de test donné auquel une vitesse de réponse du matériau à cristaux liquides (110) change en réponse à une fréquence donnée, en comparant chacune de la pluralité de réponses de fréquence de test à une réponse de fréquence de référence correspondante parmi la pluralité de réponses de fréquence de référence.

8. Unité optique (100, 300) selon la revendication 3, dans laquelle le circuit de test (104, 200) est incorporé dans une configuration de pont de Wheatstone (202), ladite configuration de pont de Wheatstone comprenant :
un premier bras (AB) comprenant le circuit de test qui est agencé entre un premier nœud (A) et un deuxième nœud (B), la première résistance (R.1) étant connectée au premier nœud et la deuxième résistance (R.2) étant connectée au deuxième nœud, dans laquelle le deuxième nœud est connecté à une source d'alimentation (204) ;
un deuxième bras (BC) comprenant un premier condensateur (C1) agencé entre le deuxième nœud et un troisième nœud (C) ;
un troisième bras (AD) comprenant un deuxième condensateur (C2) agencé entre le premier nœud et un quatrième nœud (D), dans lequel le quatrième nœud est connecté à une masse électrique (206) ; et
un quatrième bras (CD) comprenant un troisième condensateur (C3) agencé entre le troisième nœud et le quatrième nœud,
dans laquelle une unité de traitement de données (ADC) (208) est agencée entre le premier nœud et le troisième nœud,
dans laquelle lors de la détermination d'au moins l'un parmi : le vieillissement des mésogènes, le vieillissement du matériau d'alignement, la variabilité de production des mésogènes, l'au moins un processeur (106) est en outre configuré pour :
appliquer un troisième signal d'entrée au niveau du deuxième nœud pour déterminer un premier point opérationnel, dans laquelle un troisième signal de sortie correspondant au troisième signal d'entrée est mesuré par l'unité de traitement de données ;
appliquer un quatrième signal d'entrée au niveau du deuxième nœud pour déterminer un deuxième point opérationnel dans laquelle un quatrième signal de sortie correspondant au quatrième signal d'entrée est mesuré par l'unité de traitement de données ;
comparer le troisième signal de sortie et le quatrième signal de sortie pour déterminer une variation de capacité entre le premier point opérationnel et le deuxième point opérationnel ; et
lorsque la variation de capacité entre le premier point opérationnel et le deuxième point opérationnel dépasse un seuil prédéfini, identifier qu'il y a au moins l'un parmi : le vieillissement des mésogènes, le vieillissement du matériau d'alignement, la variabilité de production des mésogènes.

9. Unité optique (100, 300) selon l'une quelconque des revendications précédentes, dans laquelle, lorsque l'élément optique (102, 304) est divisé en une pluralité de zones, le circuit de test (104, 200) dans une zone donnée comprend une fraction de la première résistance, une fraction de la deuxième résistance et une fraction du condensateur de test, dans laquelle la fraction de la première résistance et la fraction de la deuxième résistance correspondent à une fraction d'une longueur totale de la trace de l'au moins une première électrode (112A) et de l'au moins une deuxième électrode (112B), respectivement, et la fraction du condensateur de test correspond à une aire du matériau à cristaux liquide,
dans laquelle le circuit de test est intégré dans l'une quelconque de : l'au moins une première électrode, l'au moins une deuxième électrode, correspondant à au moins une zone parmi la pluralité de zones, dans laquelle l'au moins une première électrode et l'au moins une deuxième électrode comprennent une pluralité de premières électrodes et une pluralité de deuxièmes électrodes, respectivement.

10. Unité optique (100, 300) selon la revendication 9, dans laquelle, lors de l'application du premier signal d'entrée au circuit de test (104, 200) pour mesurer le premier signal de sortie, l'au moins un processeur (106) est configuré pour appliquer le premier signal d'entrée au circuit de test dans la zone donnée, et
lors de l'application du deuxième signal d'entrée au circuit de test pour mesurer le deuxième signal de sortie, l'au moins un processeur est configuré pour appliquer le deuxième signal d'entrée au circuit de test dans la zone donnée.

11. Unité optique (100, 300) selon l'une quelconque des revendications précédentes, dans laquelle l'au moins un paramètre de commande comprend au moins l'un parmi : une amplitude, une fréquence, du signal de commande.

12. Unité optique (100, 300) selon l'une quelconque des revendications précédentes, dans laquelle l'au moins un paramètre optique comprend au moins l'un parmi : au moins une puissance optique à produire, une position d'au moins une région de l'élément optique (102, 304) dans laquelle l'au moins une puissance optique doit être produite, un profil de l'élément optique, une transparence d'au moins une portion de l'élément optique, un mode opérationnel de l'élément optique.

13. Unité optique (100, 300) selon l'une quelconque des revendications précédentes, dans laquelle le signal d'entrée est l'un quelconque parmi : un signal de tension impulsionnelle, un signal de tension en échelon (114), un signal de tension en rampe.

14. Procédé mis en œuvre par une unité optique (100, 300) selon la revendication 1, le procédé comprenant :
l'application d'un premier signal d'entrée à un circuit de test (104, 200) afin de mesurer un premier signal de sortie, et de déterminer une tension de crête de référence du premier signal de sortie à un premier instant temporel ;
l'application d'un deuxième signal d'entrée au circuit de test afin de mesurer un deuxième signal de sortie, et de déterminer une tension de crête de test du deuxième signal de sortie à un deuxième instant temporel ;
la détermination d'une variation d'une capacité des mésogènes entre le premier instant temporel et le deuxième instant temporel, en comparant la tension de crête de test à la tension de crête de référence ;
la détermination d'un état des mésogènes au deuxième instant temporel, sur la base de la variation de la capacité des mésogènes ; et
le réglage d'au moins un paramètre de commande d'un signal de commande pour commander au moins l'un parmi : l'au moins une première électrode, l'au moins une deuxième électrode, afin de changer au moins un paramètre optique de l'élément optique (102, 304), sur la base de l'état des mésogènes.

15. Procédé selon la revendication 14, comprenant en outre la détermination d'au moins l'un parmi : une température des mésogènes au deuxième instant temporel, un vieillissement des mésogènes, un vieillissement d'un matériau d'alignement, une variabilité de production des mésogènes, sur la base de l'état des mésogènes.
